# EUROPEAN PATENT APPLICATION

(11) **EP 4 852 692 A1**
(43) Date of publication of application: **09.12.2026**
(21) Application number: 25180218.7
(22) Date of filing: 02.06.2025
(51) Int. Cl.: H10N 60/85, C01B 32/22

(54) **GRAPHITE-BASED SUPERCONDUCTING MATERIAL**

(71) Applicant: Max-Planck-Gesellschaft zur Förderung der Wissenschaften e.V., 80539 München (DE)
(72) Inventor: MINKOV, Vasily, 55128 Mainz (DE); KSENOFONTOV, Vadim, 55128 Mainz (DE); EREMETS, Mikhail, 55128 Mainz (DE)
(74) Representative: Manitz Finsterwald Patent- und Rechtsanwaltspartnerschaft mbB

(57) **Abstract**

The present invention relates to a graphite-based superconducting material having a critical temperature *T_{c}* of 200 K or higher, as determined by four-probe electrical resistance and/or magnetic susceptibility measurements, wherein the graphite-based superconducting material is obtainable by a method comprising the following steps: Step (A): providing a liquid doping medium comprising a metal, either as a melt or in a solution, and providing graphite; Step (B): intercalating the metal into the graphite by immersing the graphite in the liquid doping medium provided in step (A) for a time period in a range of 1 second to 4 weeks to obtain a doped graphite, and Step (C): after step (B), removing the doped graphite from the liquid doping medium described in step (A) to obtain the graphite-based superconducting material.

## Description

The present invention concerns a graphite-based superconducting material.

Superconductivity is remarkable property of a material to conduct electrical current without any electrical resistance. Discovered in pure mercury by Onnes in 1911^{1,2} this property had long been considered as an exceptionally low-temperature phenomenon. The change of the paradigm came only at the end of the 80's when Bednorz and Müller revealed a new family of cuprate superconductors³. The succeeding extensive screening for high-temperature superconductivity in various cuprate compounds quickly ended with a maximum critical temperature of superconductivity, *T_{c},* of approximately 133 K at ambient pressure⁴ and 164 K under high pressure⁵. Since then, no new superconductor with a higher *T_{c}* at ambient pressure has been discovered.

The discovery of superconductivity in H₃S at megabar pressures with a *T_{c}* = 203 K⁶ marked a revolutionary step towards achieving superconductivity at or near room temperature. Soon, *T_{c}* was significantly increased in high-hydrogen-content metal superhydrides, reaching *T_{c} ≈* 244 Kin YH₉^{7,8} and *T_{c}* ≈ 250 Kin LaH₁₀^{9,10}. Subsequent theoretical calculations predict *T_{c}*s close to or even above room temperature in various hydrogen-rich systems under extremely high pressures^{11,12}.

As an alternative to hydrides, carbon-based materials can also be considered as promising candidates for high-temperature superconductivity¹³ due to their unique electronic structures, such as delocalized π-electron systems and low-dimensional frameworks, which enhance electron pairing and electron-phonon interactions. Light atomic mass of carbon contributes to higher vibrational frequencies, further strengthening these interactions.

For instance, substitution of few percent carbon atoms by boron in diamond crystal lattice results in metallic conductivity and superconductivity with a *T_{c}* near 4 K¹⁴. Heavily doped amorphous Q-carbon (≈30% boron) is a superconductor with a *T_{c}* as high as 55 K¹⁵. Doping of other allotropes of carbon - graphite, fullerenes, nano-tubes *etc.* - can also lead to appearance of superconductivity, e.g. *T_{c}* ≈ 33 K in Cs₂RbC₆₀^{16.}

Another allotrope of carbon, graphite, is a semimetal, however it can become a superconductor with an appropriate doping, e.g. by various alkali, alkaline-earth metals, and other species¹⁷. Superconductivity in the doped graphite system with the highest *T_{c}* of approximately 11.5 K has been reported in CaC₆¹⁸ and Ca₂Li₃C₆¹⁹ and can be described by BCS theory rather than an exotic electronic mechanism^{20,21}.

Despite the advances made in superconductive materials, there remains a need for further improvements to achieve *T_{c}* values closer to room temperature.

The present invention provides such superconducting materials and a way to synthesize them.

Specifically, the present invention relates to graphite-based superconducting materials as defined in claim 1 and to a layered material according to claim 15, comprising such a graphite-based superconducting material. The dependent claims define specific embodiments of the present invention.

Specifically, the present invention relates to graphite-based superconducting materials having a *T_{c}* of 200 K or higher, which can be determined by four-probe electrical resistance and/or magnetic susceptibility measurements, wherein the graphite-based superconducting material is obtainable by a method comprising the following steps:
Step (A): providing a liquid doping medium comprising a metal, either as a melt or in a solution, and providing graphite;
Step (B): intercalating the metal into the graphite by immersing the graphite in the doping medium provided in step (A) for a time period in the range of 1 second to 4 weeks to obtain a doped graphite, and
Step (C): after step (B), removing the doped graphite from the doping medium described in step (A) to obtain the graphite-based superconducting material.

The superconducting properties of the graphite-based superconducting materials described in the present invention were confirmed through independent and complementary magnetization and electrical resistance measurements. These measurements provide a number of experimental evidences characteristic of superconductivity, including:
1) diamagnetic screening and magnetic field expulsion (Meissner effect) below *T_{c}*;
2) magnetization behaviour typical of type II superconductors;
3) magnetic flux trapping;
4) a shift of *T_{c}* to lower temperatures under an applied magnetic field;
5) broadening of superconducting transitions with increasing magnetic fields;
6) distinct differences in magnetic flux trapping under zero-field-cooled (ZFC) and field-cooled (FC) modes;
7) a low rate of trapped magnetic flux creep; and
8) anomalies in electrical resistance at *T_{c}.*

A detailed description of these measurements is provided below.

While systematically exploring the occurrence of high-temperature superconductivity in various carbon-based systems the inventors have discovered a new family of superconductors exhibiting amazingly high *T_{c}* reaching at least 350 K at atmospheric pressure. The general research challenge was inspired by the possibility of high-temperature conventional superconductivity^{22,23} in compounds consisting of light elements (e.g. H, B, C, N *etc.*)^{24,25}*.*

The graphite-based superconducting material can be produced using a relatively simple method that does not require high-pressure synthesis, such as diamond anvil techniques or other methods that are difficult or impractical to scale up. Instead, the graphite is immersed in a liquid doping medium, a process that can be conducted at or slightly above atmospheric pressure. Here, atmospheric pressure refers to 1 bar.

The liquid doping medium may consist of either a molten metal or a molten metal alloy. Alternatively, it may be a metal in a solution, which is a metal dissolved in a solvent, such as for example ammonia, ethylenediamine, methylamine or dimethylamine. In such a solution, there can be solvated electrons and solvated metal ions. For the sake of simplicity, this is referred to herein as metal in a solution.

In one embodiment, the liquid doping medium provided in step (A) comprises the metal in a liquid state as a molten metal/alloy. Specifically, the liquid doping medium can be a mixture of lithium and one or more other metal(s). While lithium intercalation alone does not induce high-*T_{c}* superconductivity, its presence may be beneficial due to the proximity effect, where the superconducting properties can be projected into the lithium.

Additionally, experimental observations indicate that in the graphite-based superconducting material disclosed here, the number of free carriers at the Fermi level is an order of magnitude higher in the presence of co-intercalated metals compared to pure lithium intercalation. This suggests that both components may play a role in superconducting properties. Furthermore, lithium atoms expand the graphite interlayer spacing during intercalation, facilitating the incorporation of other metals into the graphite matrix.

Moreover, combining lithium with other metals significantly lowers the melting point of the mixture compared to that of the non-lithium metal alone. As discussed in more details below, experimental results show that performing intercalation in step (B) at lower temperature promotes the formation of a larger fraction of the high-*T_{c}* superconducting phase while minimizing the presence of a possible low*-T_{c}* superconducting phase. Specific liquid doping media can be one of the following alloys: Ca-Li, Sr-Li, Ca-Sr-Li, K-Li, Mg-Li, Zn-Li, and Mg-Zn-Li.

According to another embodiment, the liquid doping medium provided in step (A) comprises the metal dissolved in a solution. A specific solvent for the metal can be liquified ammonia. Specifically, in this embodiment, the metal can be a metal different from lithium.

For both embodiments, the non-lithium metal can be either monovalent or heterovalent to lithium. Specifically, the non-lithium metal can be at least a metal selected from the group consisting of Sodium (Na), Potassium (K), Rubidium (Rb), Cesium (Cs), Beryllium (Be), Magnesium (Mg), Calcium (Ca), Strontium (Sr), Barium (Ba), Zinc (Zn), Cadmium (Cd), Mercury (Hg),Yttrium (Y), Lanthanum (La), Cerium (Ce), Europium (Eu), Titanium (Ti), Scandium (Sc), Niobium (Nb), Vanadium (V), Molybdenum (Mo), Rhenium (Re), Aluminum (Al), Gallium (Ga), Indium (In), Thallium (TI), Tin (Sn), Lead (Pb), Antimony (Sb), Bismuth (Bi) and combinations thereof, specifically selected from the group consisting of K, Ca, Sr, Mg and Zn and combinations thereof, more specifically a combination of Ca and Sr.

When the graphite-based superconducting material is obtained by providing a liquid doping medium in step (A), as a melt of lithium and a non-lithium metals, the atomic ratio of non-lithium to lithium can range from 1:1 to 1:100, in particular from 1:2 to 1:90, and more specifically from 1:3 to 1:80. If the concentration of the non-lithium metal (e.g., Ca) is too high in the melt, a concomitant superconducting phase, likely CaC₆ or Ca₂Li₃C₆ phase, with a *T_{c}* raging from approximately 7 to 11.5 K, may form. Notably, decreasing the concentration of the non-lithium metal in the melt reduces the yield of the concomitant low-temperature superconducting phase with a *T_{c}* below 12 K.

Graphite provided in step (A) is not specifically limited. In principle, the graphite material can be in any form. From the viewpoint of removing the doped graphite from the doping medium in step (C) more easily, graphite can be in a form of a granulate, a fibrous material, a monolithic material, a coating, a foam, a film, or a composite material. The monolithic material can also be provided as a mesh, a wire, or a thread. Examples of the graphite material are highly oriented pyrolytic graphite or high-purity flexible graphite sheets.

The graphite provided in step (A) may be pre-treated to remove absorbed gases and water from its interior. This treatment can be conducted at temperatures of 200 °C or higher, 300 °C or higher, or 400 °C or higher. The treatment duration can be 20 minutes or longer, 40 minutes or longer, 1 hour or longer. It can be performed in an oxygen free atmosphere, such as an argon atmosphere, more specifically a reducing argon atmosphere containing hydrogen.

When obtaining the graphite-based superconducting material, the temperature of the doping medium in step (B) can be equal to or less than 500 °C when the doping medium comprises the metal as a melt. More specifically, the temperature is below 450 °C, and even more specifically, bellow 300 °C. It was observed that maintaining the doping medium below these temperatures increases the observed *T_{c}* in a product.

Further, the time period in step (B), i.e., the time during which the graphite is immersed in the liquid doping medium, is in the range of 1 second to 4 weeks. More specifically, the time period can be in the range from 3 seconds to 3 weeks, even more specifically from 5 seconds to 9 days, even further more specifically from 10 seconds to 24 hours, even further more specifically from 1 minute to 18 hours, even further more specifically from 2 minutes to 12 hours, even further more specifically from 2 minutes to 6 hours, even further more specifically from 2 minutes to 3 hours, even further more specifically from 2 minutes to 1.0 hours, and most specifically from 3 minutes to 20 minutes. It was found that the obtained material exhibits high-temperature superconductive properties, with a critical temperature *T_{c}* as indicated in claim 1, even after very short intercalation times of a few seconds, as well as after longer intercalation times of several weeks. However, it was also observed that prolonged intercalation leads to higher yield of a concomitant superconducting phase, likely CaC₆ or Ca₂Li₃C₆, with a *T_{c}* raging from approximately 7 to 11.5 K. By adapting the time of intercalation, the fraction of the high-temperature superconductive phase can be increased.

When obtaining the graphite-based superconducting material, the temperature of the doping medium in step (B) can be equal to or below 0°C, in particular equal to or below -70°C, when the doping medium comprises the metal dissolved in a solution. More specifically, the metal in the doping medium is dissolved in liquid ammonia. In such a doping medium, ammonia can act as an adjuvant for the solvated metal facilitating its intercalation into the graphite material.

During the immersion and intercalation in step (B), the pressure can be 1 bar or higher but less than 100 bar, more specifically less than 50 bar, even more specially less than 5 bar and most specifically less than 2 bar. For example, during synthesis in a glove box, there is typically a slight over pressure inside the glove box, so that the pressure is typically slightly above 1 bar, in particular around 1.01 bar. By keeping the pressure in these ranges, the graphite-based superconductive material disclosed herein can be easily produced.

The method for obtaining the graphite-based superconductive material disclosed herein is preferably carried out in a substantially dry and substantially oxygen free atmosphere. A substantially dry and oxygen free atmosphere relates to conditions which do not readily degrade the doping medium or the obtained graphite-based material. The water content can be 100 ppm or lower, specifically 50 ppm or lower, even more specifically 25 ppm or lower, most specifically 1 ppm or lower. The oxygen content can be 100 ppm or lower, specifically 50 ppm or lower, even more specifically 25 ppm or lower, most specifically 1 ppm or lower. These values can be measured by conventional oxygen and water sensors known in the art.

In step (C), extraction of the doped graphite from the doping medium to obtain the graphite-based superconducting material can be achieved, e.g., by lifting the doped graphite out of the doping medium, draining the doping medium from the reaction vessel, or by evaporating the doping medium or a part thereof, such as the solvent, specifically ammonia, such that the doped graphite remains in the reaction vessel.

The graphite-based superconducting material according to the present disclosure has a *T_{c}* of 200 K or higher at atmospheric pressure, specifically of 220 K or higher, more specifically of 230 K or higher, even more specifically of 240 K or higher, more specifically of 250 K or higher, more specifically of 270 K or higher, most specifically of 350 K or higher. *T_{c}* values can be determined by four-probe electrical resistance and/or magnetic susceptibility measurements.

Such unexpectedly high *T_{c}* ranging from approximately 230 K to 260 K came with samples of graphite intercalated by metal-ammonia solutions, in particular Ca-NH₃ solutions. As alternatives to extremely reactive metal-ammonia solutions it was found that intercalation of graphite by molten metal alloys, specifically lithium-based alloys, yields more stable products and leads to significantly higher *T_{c}* values reaching 350 K.

The graphite-based superconducting material according to present disclosure has at atmospheric pressure a *T_{c}* of 400 K or lower, in particular of 375 K or lower, more specifically of 360 K or lower.

The graphite-based superconducting material disclosed herein may have at least in portions thereof a rhombohedral structure, in particular after immersion in the doping material. There are theoretical considerations demonstrating that the rhombohedral phase of graphite is especially promising for high-*T_{c}* superconductivity due to its topologically protected surface states with flat bands at the Fermi energy³⁵. It was assumed that stacking faults and interfaces between different stackings of graphite, including boundaries between inclusions of rhombohedral phase, can result in emergence of flat bands. A proper doping provides high density of states (DOS) and leads to large coupling constant further favouring high-*T_{c}* superconductivity.

In the graphite-based superconducting material disclosed herein, the doping metal atoms are intercalated between graphene layers. As shown by EDX measurement, obtained from bulk samples which were split before measurement along the graphene layers, the doping metal atoms are present throughout the bulk material. Despite the short intercalation time, penetration of the metal, in particular the non-lithium metal, into the bulk graphite occurs.

High-temperature superconductivity was observed for graphite-based materials that are hydride free and/or sulfur free, in particular hydride and sulfur free. A hydride and sulfur free graphite-based material may still include impurities of sulfur or hydride compounds; the amount of these impurities is such that the content thereof is below 0.5 wt.-%, in particular below 0.2 wt.% of the graphite-based material. In WO 2024/191906 A1, sulfur containing materials are described, which, however require extremely high pressure for their synthesis, i.e., they were obtained by an entirely different method than disclosed herein for the graphite-based superconducting material of the present disclosure.

Further disclosed is a layered material, comprising a graphite-based superconducting material. The graphite-based superconducting material has a *T_{c}* of 200 K or higher, which can be determined by four-probe electrical resistance and/or magnetic susceptibility measurements. The layered material comprises a graphite-based host structure, formed of two-dimensional graphene layers made of carbon atoms, wherein doping metal atoms are intercalated in the host structure, and wherein in the bulk of the layered material, a ratio of the sum of doping metal atoms to carbon atoms is 0.35 or less, or 0.15 or less, wherein, in case lithium atoms are present, these lithium ions are not included in the sum of metal atoms.

In the disclosed layered material, the graphite-based superconducting material can be a component of the entire layered material. Even in such cases, superconductivity in a fraction of the material can significantly reduce its overall electrical resistance, effectively shield electromagnetic radiation, and influence magnetic fields. Furthermore, due to proximity effects, the graphite-based superconducting fraction can induce superconducting properties in the adjacent non-superconducting, lithium-containing metallic component.

In the layered material disclosed herein, the average stage of intercalation may be equal to or greater than 1.0. In the context of the present disclosure, a stage of intercalation of 1.0 means that every interlayer between graphene sheets is doped with metals. A higher stage of intercalation, such as an average of 2.0, indicates that every second interlayer is doped; an average of 3.0, indicates that every third interlayer is doped. The average stage of intercalation may be 1.5 or higher, or 2.0 or higher, or 5 or higher, or 10 or higher.

Further, the metal atoms intercalated between graphene layers of the layered material disclosed herein may comprise lithium atoms and non-lithium metal atoms, for example a divalent metal atom. As noted above, the additional presence of lithium may be advantageous due to the proximity effect and due to an increased number of free carriers on the Fermi level.

In the layered material disclosed herein, the atomic ratio of lithium atoms to non-lithium metal atoms may be equal to or greater than 2.5, equal to or greater than 3.0, equal to or greater than 4.0, or even equal to or greater than 6.0. For liquid doping media with a relatively large amount of lithium compared to other metal(s), it was observed that the yield of low*-T_{c}* superconducting concomitant phase can be suppressed and the formation of the high-*T_{c}* superconducting phase can be favored. It is assumed that this is due to a dilution of metal atoms different from lithium. For the sake of clarity, it is noted that "atoms of the metal atoms different from lithium" relates to the sum of these metal atoms, i.e., in a Li-Sr-Ca alloy, it refers to the sum of Sr and Ca atoms.

The graphite-based host structure of the layered material disclosed herein can have at least in portions thereof a rhombohedral structure. For example, the graphite-based material has structural domains with a rhombohedral arrangement and stacking faults or irregularities, resulting in the formation of three or more-layer rhombohedral packing of graphene layers in a bulk of the graphite-based material. As shown in the example section and mentioned already above, presence of the rhombohedral phase may promote a favored formation of the high *T_{c}* fraction over the formation of a low *T_{c}* fraction. Theoretical considerations indicated above for the graphene-based superconducting material apply also to the layered material disclosed herein.

More specifically, the layered material disclosed herein may be obtainable by the method steps (A), (B) and (C) disclosed herein in the context of the graphite-based superconducting material.

It is to be understood that a synthesis method comprising these method steps (A), (B) and (C) forms also part of the present invention.

Further, the present invention will be described by reference to specific examples and drawings, which do not limit the scope of the invention.

In the drawings the following is shown:
- Fig. 1:: Magnetization *m(T)* measurements of graphite samples intercalated by ternary calcium-strontium-lithium alloys.
- Fig. 2:: Magnetization *m(T)* measurements of graphite samples intercalated by K-Li, Sr-Li, Mg-Li, Zn-Li, and Mg-Zn-Li alloys.
- Fig. 3:: Magnetization *m(T)* measurements of graphite samples intercalated by calcium-ammonia solutions and calcium-strontium-lithium alloys **(a-c).** Several photos of graphite samples intercalated by Li-Ca alloys **(d-f)** and Ca-NH₃ solutions **(g, h).**
- Fig. 4:: Magnetization *m(T)* measurements of graphite samples intercalated by calcium-ammonia solutions.
- Fig. 5:: Magnetization *m(T)* measurements of graphite samples intercalated by binary calcium-lithium alloys.
- Fig. 6:: Magnetic field dependence of superconducting transitions in graphite samples intercalated by calcium-strontium-lithium alloys.
- Fig. 7:: Trapping of magnetic flux by superconducting phases in in graphite samples intercalated by calcium-ammonia solution and calcium-strontium-lithium alloy.
- Fig. 8:: Time dependence of trapped magnetic moment at *T* = 12.2 K, 130 K, and 260 K.
- Fig. 9:: Four-probe electrical resistance measurements of graphite samples intercalated by calcium-ammonia solutions and calcium-strontium-lithium alloys.
- Fig. 10:: Magnetization *m(T)* measurements of graphite samples intercalated by binary calcium-lithium alloys for different time.
- Fig.11:: Energy dispersive X-ray analysis of the graphite intercalated by binary Li-Sr alloy.
- Fig. 12:: Energy dispersive X-ray analysis of the graphite intercalated by ternary Li-Ca-Sr alloy.
- Fig. 13:: Energy dispersive X-ray analysis of the graphite intercalated by ternary Li-Ca-Sr alloy.
- Fig. 14:: Energy dispersive X-ray analysis of the graphite intercalated by binary Li-Mg alloy.
- Fig. 15:: Energy dispersive X-ray analysis of the graphite intercalated by binary Li-Ca alloy.
- Fig. 16:: Energy dispersive X-ray analysis of the pristine graphite source (HOPG).
- Fig. 17:: Energy dispersive X-ray analysis of the pristine graphite source (SGL).
- Fig. 18:: Magnetic field dependence of superconducting transitions in graphite samples intercalated by magnesium-lithium alloy.
- Fig. 19:: Magnetic field dependence of superconducting transitions in graphite samples intercalated by zinc-lithium alloy.

### Materials and Methods

Two different sources of graphite for the reproducible synthesis of superconducting samples were used: highly oriented pyrolytic graphite, HOPG (purity 99,99%, Magnametals), and sheets of compacted graphite, SGL (purity > 98%, SGL CARBON GmbH).

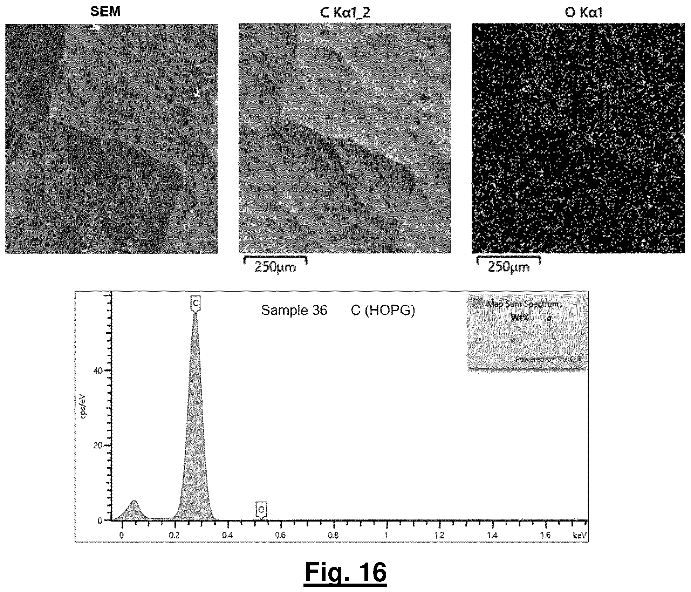

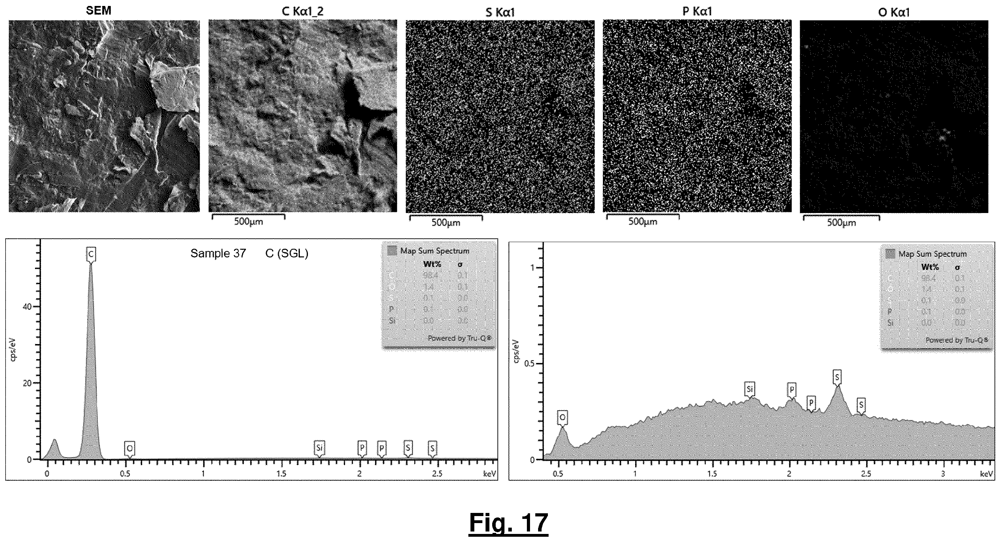

The energy dispersive X-ray (EDX) analysis of both pristine graphite sources confirms their claimed high purity (see Fig. 16 and 17).

Prior intercalation of graphite samples either by metal-ammonia solutions or lithium-based metal alloys the graphite source was annealed at *T* = 450 °C in Ar-H₂ (5 mol% H₂) flow for 2 hours to remove absorbed gases and water from its interior. Untreated SGL and HOPG sources were also used in our experiments, however the reproducibility rate of products exhibiting high-*T_{c}* superconductivity was low.

For the synthesis of granite-based superconducting materials, the following reactants were used:
NH₃ (99.999%, Westfalen),
Ca (99.5%, redistilled, Alfa Aesar),
Li (99.9%, Alfa Aesar),
Sr (99.9%, Alfa Aesar),
K (99.9%, Alfa Aesar),
Mg (99.8%, Alfa Aesar),
Zn (99.999%, Alfa Aesar),
anhydrous silicone oil and kerosene both dried with metallic sodium in Ar atmosphere. Paraffin wax degassed by pumping above melting point was also used for protection of synthesized samples from the air during handling.

Intercalation of graphite samples can be performed by two different techniques. The first technique includes metal-ammonia solutions as an intercalation medium, the second technique includes molten Li-based metal alloys. Both techniques provide good dissolution of the doping metals at temperatures significantly lower than their melting points and effective delivery of these metals into the graphite matrix.

### Example I

### Intercalation of graphite samples with calcium-ammonia solutions.

Intercalation of graphite samples with calcium-ammonia solutions was conducted, following the subsequent protocol, using 25-ml-volume Schlenk flasks and 21-ml-volume test-tubes. Glassware was meticulously cleaned, including cleaning in a base bath (potassium hydroxide / isopropanol), and in a 3:1 mixture of concentrated HCl and HNO₃ acids, followed by thorough rinsing by deionized water. The glassware was then dried at 150 °C for 24 hours to remove adsorbed water, which can cause the decomposition of metal-ammonia solutions.

For the typical synthesis, a bulk piece of graphite and weighed pieces of metallic Ca were transferred into the glassware, which was then sealed under an argon atmosphere in a glovebox with residual O₂ and H₂O levels below 0.1 ppm. The glassware containing the reactants was connected to a condensation setup and evacuated to approximately 10⁻⁵ bar. In order to remove traces of air, the entire condensation line was purged with gaseous NH₃ and vacuumed multiple times.

The condensation of liquid ammonia and the synthesis were done in glassware at approximately -70 °C using a dry ice-ethanol bath. Some syntheses were done using liquid N₂-ethanol base to reach approximately -90 °C. Upon condensation, NH₃ immediately starts to react with Ca pieces. During the preparation of Ca-NH₃ solutions, graphite samples were in contact with the reaction liquid. In addition, graphite samples were immersed into the prepared Ca-NH₃ solutions after the condensation of NH₃. The intercalation process was carried out at -70°C for 30-120 minutes. The concentration of Ca in metal-ammonia solutions varied from approximately 1-5 mol% in dilute solutions (dark blue solutions) to approximately 15 mol% in saturated solutions with excess metal phase (yielding bronze solutions with a metallic luster).

After the intercalation reaction, the following protocol was applied:
1*. Removal of excess NH₃:* The reaction mixture was pumped out at *T* ≈ -70 °C for approximately 0.2-1 hour until the metal-ammonia solutions solidified.
2*. Warming:* The mixture was warmed to room temperature while continuing to pump for approximately 10-20 minutes.
3*. Atmosphere restoration:* The pump was turned off, and the glassware was filled with helium gas (99.999% Westfalen) to approximately 1 bar.
4*. Protection:* Anhydrous silicone oil or kerosene was added in the flask to protect the highly reactive products from the contact with ambient air.
5*. Extraction:* The intercalated graphite samples were mechanically separated from the metal-ammonia solids.

To explore whether the superconducting fraction in prepared graphite-based superconducting materials could be enhanced, some samples underwent multiple intercalation cycles. This process involves repeated immersions of graphite into Ca-NH₃ solutions. After each immersion, the sample was lifted above metal-ammonia solution. The bottom end of the flask was immersed into liquid N₂ to allow the solution being frozen, and excess NH₃ in the lifted samples was pumped out for approximately 10 minutes. Then metal-ammonia solution was melted at *T* ≈ -70 °C in a dry ice-ethanol bath and the intercalation was repeated. Samples subjected to 3 and 10 intercalation cycles showed no significant improvement in the superconducting fraction.

Attempts to intercalate graphite samples with other metal-ammonia solutions, e.g., Sr-NH₃, Na-NH₃, and K-NH₃, were not successful due to extremely high reactivity of these solutions, which often led to spontaneous combustion and sample bursts during subsequent sample handling.

Intercalated graphite samples were transferred to a precooled SQUID magnetometer for magnetization measurements, typically within 2-5 minutes.

The intercalated graphite samples initially exhibit a fascinating gold and dark-blue surface upon delamination, evoking the artistic brilliance of Gustav Klimt's works. However, over time, these colors faded, and the surface acquired a bronze hue, likely due to intercalant degradation. Bubbling, indicative of ammonia evaporation from the graphite matrix, was also observed. Even after several months at room temperature, the samples retained the characteristic odor of ammonia.

### Example II

### Intercalation of graphite samples with the doping metal-lithium alloys.

Another approach for doping the graphite samples via a liquid phase involves the use of lithium-based metal alloys, following the alternative protocol. For instance, calcium, strontium, magnesium and zinc metals readily form alloys with lithium that remain liquid at temperatures significantly lower than the corresponding melting points of pure metals³⁶⁻³⁹. Unlike intercalation by metal-ammonia solutions, using lithium-based metal alloys for the intercalation reaction offers several advantages: parameters, such as temperature, synthesis duration, and the concentration of doping metals in alloys, can be more precisely controlled. More importantly, the intercalated samples are stable at room temperature, as they do not contain ammonia, which can readily evaporate from the graphite matrix and chemically react with the doping metal at room temperature.

Intercalation reactions using lithium-based metal alloys were carried out in a stainless-steel crucible heated by a furnace under an inert argon atmosphere within a glove box at about 1 bar. Freshly cut pieces of lithium and the doping metal were weighed and placed in the crucible, then melted at temperatures ranging from 150 to 450 °C upon stirring to ensure a homogeneous alloy. The graphite samples were then immersed in the prepared liquid alloy with the maintained required temperature for intercalation.

The intercalation time varied from 5 seconds to several days, after which the samples were removed from the melt and allowed to cool to room temperature. Prior transportation from the glove box the prepared samples were covered by dried silicon oil or paraffin.

The intercalation of graphite by Ca-Li alloys may result in the formation of a concomitant superconducting phase, likely CaC₆ or Ca₂Li₃C₆ phase, with a *T_{c}* raging from approximately 7 to 11.5 K. By adjusting the temperature, intercalation time, and concentration of the doping metal Ca in Ca-Li alloys, the ratio between high-*T_{c}* and the concomitant low*-T_{c}* phases can significantly vary. This indicates that the observed high-*T_{c}* values do not correlate with, nor are they related to, the low*-T_{c}* phase.

Notably, decreasing the concentration of Ca in Ca-Li alloys from a 1:3.5 to a 1:50 Ca:Li atomic ratio significantly reduced the fraction of the low*-T_{c}* phase.

To further reduce the formation of the low*-T_{c}* concomitant phase, a competing alkaline-earth metal, Sr, was added to the intercalating Ca-Li alloy. Strontium, like calcium can form SrC₆ compound with a significantly lower superconducting *T_{c}* of 1.65 K⁴⁰.

Following table 1 summarizes synthesis conditions for different samples prepared either by the synthesis protocol of Example I or by the synthesis protocol of Example II.

**Table 1:**

| Synthesis Protocol | Intercalation metal(s) | Atomic Ratio of metals | Intercalation Time | Intercalation Temperature | *Tc* |
|---|---|---|---|---|---|
| Example I | Ca-NH₃ | Ca = 1 | 10 to 180 minutes | -90 to -70 °C | 230 K to 260 K |
| Example II | Ca-Li | Li:Ca = 3.5:1 to 50:1 | 10 seconds to 2 weeks | 250 to 450 °C | 230 K to 270 K |
| | Ca-Sr-Li | Li:Ca:Sr: 20:2:1; 20:1:1 | 1 to 10 minutes | 200 to 350 °C | 250 K to 350 K |
| | Sr-Li | Li:Sr = 3:1 | 20 to 60 seconds | 350 °C | 240 K |
| | K-Li | Li:K = 3:1 | 0.5 to 4 minutes | 250 °C | 240 K |
| | Mg-Li | Li:Mg = 4:1 | 5 minutes | 350 °C | 260 K to 350 K |
| | Zn-Li | Li:Zn = 4:1 | 5 minutes | 300 °C | 270 K to 350 K |
| | Mg-Zn-Li | Li:Mg:Zn = 8:1:1 | 4 minutes | 250 °C | 300 K to 350 K |

In Table 1, a range for the intercalation time indicates that several samples were prepared, wherein the intercalation time was varied between individual samples within the indicated time range. The range for *T_{c}* defines the range of critical temperatures that were measured for individual samples. Similarly, atomic ratios of metals define a range, several samples covering that range were prepared. When specific value(s) is(are) indicated, corresponding samples were prepared.

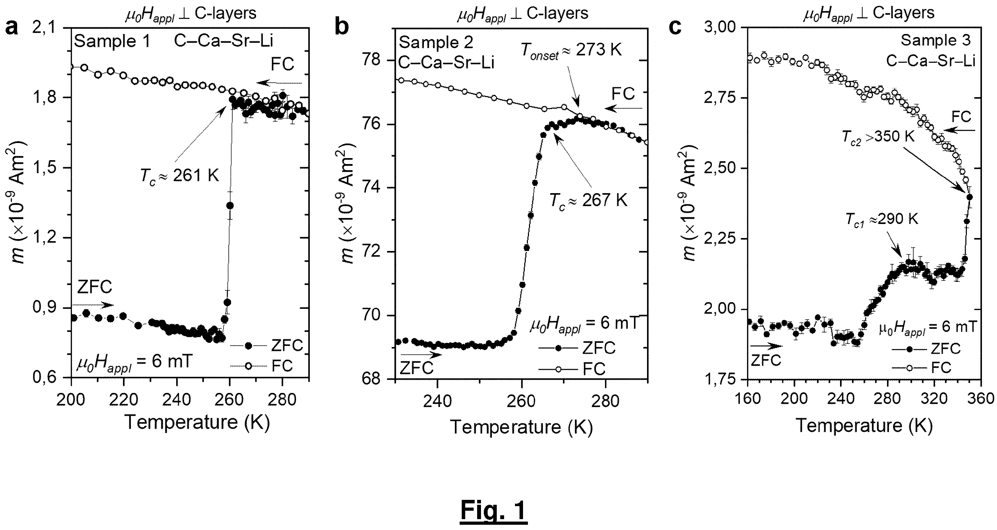

The intercalation of graphite samples with ternary Ca-Sr-Li metal alloys led to a reduction in the Δ*m* of the superconducting transition in the concomitant phase with a *T_{c}* below 12 K by up to 10⁵ times. Meanwhile, the Δ*m* of the superconducting transition in the high-*T_{c}* phase remained unchanged, with the *T_{c}* value reaching up to 350 K (see Figure 1).

Figure 1 shows the results of magnetization *m(T)* measurements of graphite samples intercalated by ternary calcium-strontium-lithium alloys. Figure 1a shows ZFC and FC *m(T)* data for Sample 1 showing the superconducting transition at *T_{c}* ≈ 261 K. Sample 1 was synthesized by intercalation of graphite (SGL) by Li-Ca-Sr alloy of 20Li:1Ca:1Sr atomic ratio at *T* = 250 °C for 60 seconds. Figure 1b shows ZFC and FC *m(T)* data for Sample 2 showing the superconducting transition at *T_{c}* ≈ 267 K extended to a higher *Tₒₙₛₑₜ* ≈ 273 K. Sample 2 was synthesized by intercalation of graphite (SGL) by Li-Ca-Sr alloy of 20Li:2Ca:1Sr atomic ratio at *T* = 350 °C for 60 seconds. In Figure 1c ZFC and FC *m(T)* data for Sample 3 are shown, demonstrating the superconducting transition at *T_{c2}* above 350 K with a preceding step at *T_{c1}* ≈ 290 K, which may indicate the inhomogeneity of the superconducting phase(s). Sample 3 was synthesized by intercalation of graphite (SGL) by Li-Ca-Sr alloy of 20Li:2Ca:1Sr atomic ratio at *T*= 200 °C for 10 minutes. Applied magnetic fields were perpendicular to carbon layers in samples.

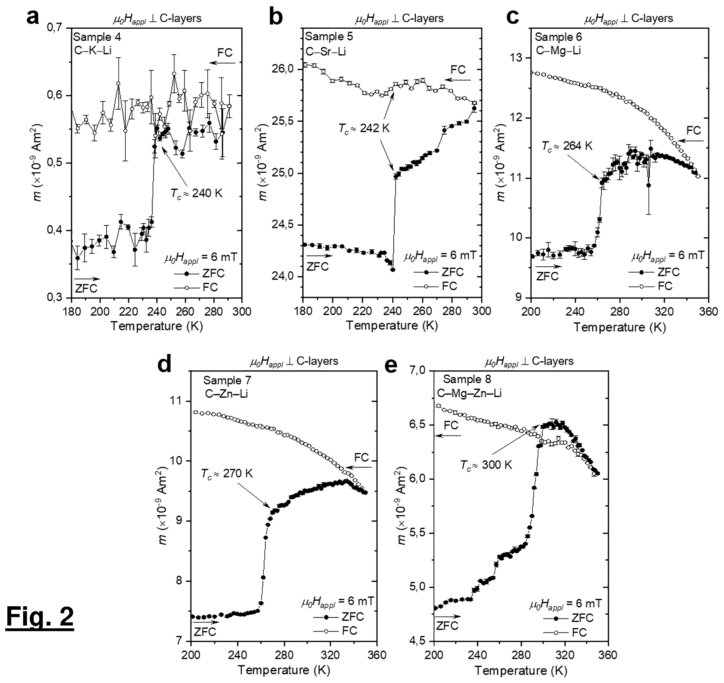

Further, intercalation of graphite samples using other binary and ternary alloys, including Sr-Li, K-Li, Mg-Li, Zn-Li, and Mg-Zn-Li alloys was investigated. The preparation of these alloys and the subsequent intercalation reaction of graphite samples was followed by similar protocol as for Ca(Sr)-Li alloys. The temperature and intercalation time of the synthesis are provided for each sample in Table 1. The corresponding superconducting transitions are shown in Figure 2.

Figure 2 show magnetization *m(T)* data measured in graphite samples intercalated by K-Li, Sr-Li, Mg-Li, Zn-Li, and Mg-Zn-Li alloys. Figure 2a shows ZFC and FC *m(T)* data for Sample 4 showing the superconducting transition at *T_{c}* ≈ 240 K. Sample 4 was synthesized by intercalation of graphite (SGL) by Li-K melt of 3Li:1K atomic ratio at *T* = 250 °C for 30 seconds. Figure 2b shows ZFC and FC *m(T)* data for Sample 5 showing the superconducting transition at *T_{c}* ≈ 242 K. Sample 5 was synthesized by intercalation of graphite (SGL) by Li-Sr alloy of 3Li:1Sr atomic ratio at *T* = 350 °C for 60 seconds. Figure 2c shows ZFC and FC *m(T)* data for Sample 6 showing the superconducting transition at *T_{c}* ≈ 264 K. Sample 6 was synthesized by intercalation of graphite (SGL) by Li-Mg alloy of 4Li:1Mg atomic ratio at *T* = 350 °C for 5 minutes. Figure 2d shows ZFC and FC *m(T)* data for Sample 7 showing the superconducting transition at *T_{c}* ≈ 270 K. Sample 7 was synthesized by intercalation of graphite (SGL) by Li-Zn alloy of 4Li:1Zn atomic ratio at *T* = 300 °C for 5 minutes. Figure 2e shows ZFC and FC *m(T)* data for Sample 8 showing the superconducting transition at *T_{c}* ≈ 300 K. Sample 8 was synthesized by intercalation of graphite (SGL) by Li-Mg-Zn alloy of 8Li:1Mg:1Zn atomic ratio at *T* = 250 °C for 4 minutes. Applied magnetic fields were perpendicular to carbon layers in samples.

### Magnetic susceptibility measurements

D.c. magnetic susceptibility measurements were done using the S700X SQUID magnetometer by Cryogenic Limited. Several small pieces of sample (a length and width of ≈2-3 mm, a thickness of ≈0.1-2 mm) with a total mass of approximately 5-30 mg were covered by anhydrous kerosene or silicone oil and put into a gelatine capsule (an inner diameter of ≈4 mm). Samples were predominantly oriented with carbon layers perpendicular to the applied magnetic field. For some measurements samples were oriented with carbon layers parallel to the magnetic field.

*T_{c}* was determined as the onset of the diamagnetic transition on the ZFC and FC (as applicable) curves of the temperature dependence of magnetic moment *m(T).* The geometry-dependent value of the penetration filed *Hₚ* at which an applied magnetic field starts to penetrate a superconductor was determined from the magnetization *m*(*T,H*) measurements as the onset of the evident deviation of the Δ*m*(*H*) from the linear dependence.

The trapped magnetic flux was generated under ZFC and FC conditions. The typical ZFC protocol includes cooling of the sample at zero field from *T>T_{c}* to the target temperature below *T_{c}.* At the target temperature the magnetic field was applied for approximately 1 hour, then the applied magnetic field was gradually decreased to 0 T. In FC mode the sample was cooled from its normal state at the applied magnetic field to the target temperature below *T_{c},* waiting for approximately 1 hour, and then an applied magnetic field was gradually decreased to 0 T. After removing an applied magnetic field in both ZFC and FC modes the SQUID magnetometer was allowed to stand at 0 T for approximately 4 hours to prevent successive measurements of *mₜᵣₐₚ*(*T*) from outliers associated with jumps of flux in a superconducting magnet. An applied magnetic field of magnetization ranged from 16 mT to 2 T. Successive *mₜᵣₐₚ*(*T*) measurements were performed upon warming of the sample with a temperature step of 1-3 K. Before each cycle of magnetization, the sample was converted to its normal metal state by warming the sample to *T>T_{c}* at zero field and the superconducting magnet of SQUID was degaussed to eliminate the remnant fields.

### Electrical transport measurements

Four-probe resistance measurements were done on bulk samples of rectangular shape in two configurations with excitation current along and perpendicular to samples layers. The samples were connected to electrical probes using a special holder with gold-plated contact pins in Ar glovebox. A Si diode temperature sensor was placed close to the sample in quartz ampule filled with He exchange gas at atmospheric pressure. An excitation current from AC resistance bridge (Model 372, Lake Shore) with amplitude of 33 µA - 1 mA and frequency of 13 Hz caused a minimal heating of the sample due to a low scattered heating power about 0.1 nW.

Four-probe resistance measurements were also done in SQUID magnetometer in a temperature range of 3 - 350 K and magnetic fields up to 7 T. We applied the above-mentioned electronic setup based on the a.c. resistance bridge.

The protocol used for preparation of samples intercalated by Ca-ammonia solutions for electrical resistance measurements included: *i*) after the intercalation reaction, samples were removed from liquid metal-ammonia solutions and kept lifted above the liquid; and ii) reducing the pressure of ammonia vapor in reaction glassware to approximately 0.8 bar. Electrical resistance measurements were performed in situ in the same test-tubes used for the synthesis. For these measurements we used a sample holder equipped with four electrical contacts and an attached Si diode temperature sensor, which both are movable inside test-tubes. Typically, elongated thin HOPG samples with a size of approximately 3×1×0.3 mm³ were connected with four electrical contacts made of gold wire with a diameter of 0.07 mm or Pt wire of diameter 0.1 mm. The most stable measurements were done with thin ~0.1-mm-thickness slabs of graphite (HOPG). In these measurements apparently both in-plane and normal-to-plane components input in the signal. The in-plane component of conductivity should be much larger and likely it prevails in the measurements.

### Scanning electron microcopy and energy dispersive X-ray analysis

Scanning electron microcopy of pristine and intercalated graphite samples was done using Ferra III Focus ion beam device (Tescan). The energy dispersive X-ray analysis was performed using device (Oxford Instruments) integrated in Ferra III FIB.

### Results

The conformed experimental signature of superconductivity in novel graphite intercalation compounds is provided by independent and complementary magnetization and electrical resistance measurements. A number of experimental evidences that can be attributed to hallmarks of superconductivity are observable, including: 1) diamagnetic screening and magnetic field expulsion (the Meissner effect) of the applied magnetic field below a *T_{c}*; 2) the characteristic for type II superconductors behaviour of magnetization; 3) magnetic flux trapping; 4) shift of *T_{c}* to lower temperatures in external magnetic fields; 5) broadening of superconducting transitions with applied magnetic fields; 6) the characteristic difference in the trapping of magnetic flux under ZFC and FC protocols; 7) low rate of trapped magnetic flux creep; and 8) anomalies in electrical resistance at *T_{c}.*

### 1. Screening and expulsion of applied magnetic fields (the Meissner effect).

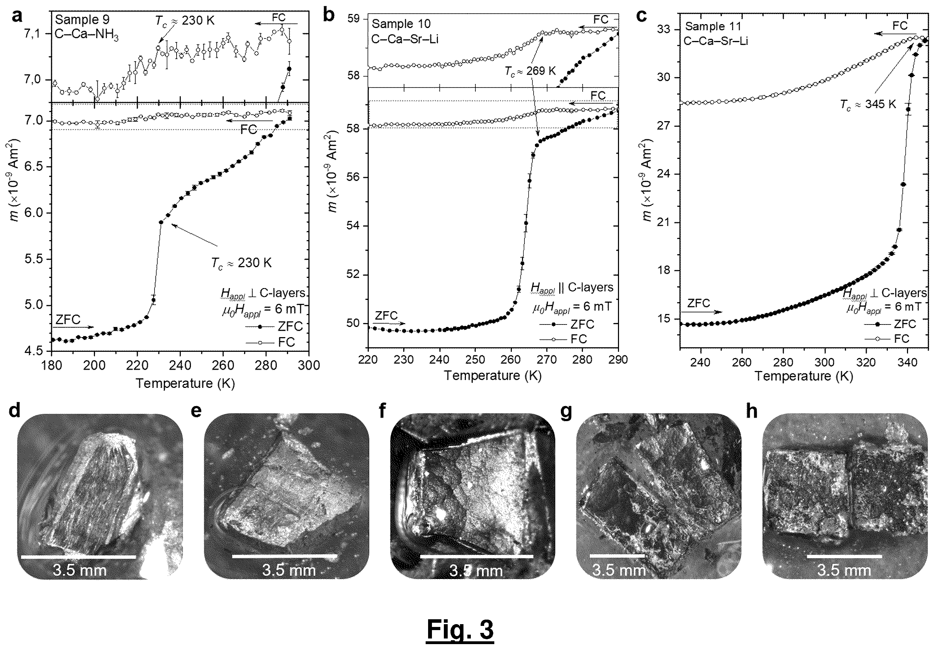

The samples, synthesized by two different techniques using either metal-ammonia solutions (see details given described above as Example I) or melts of lithium-based metal alloys (see details described above as Example II) for intercalation of graphite, demonstrated pronounced steps in *m*(*T*) magnetization measurements in the temperature range of approximately 230-345 K (see Figure 3).

The steps on *m(T)* data are apparent in zero-field-cooled mode (ZFC) and much smaller or negligible in field-cooled mode (FC), which is quite common for type II superconductors, especially for samples with strong pinning of vortices. The expulsion of applied magnetic fields or the Meissner effect (FC mode) could be observed in samples intercalated by both metal-ammonia solutions (Sample 9, see Figure 3a) and Ca-Sr-Li alloys (Samples 10 and 11 in Figure 3b and 3c, respectively). For example, the change of magnetic moment at the superconducting transition, Δ*m*, under FC conditions in Samples 9, 10 and 11 varies approximately from 7% to 22% of Δ*m* values measured under ZFC protocol.

Figure 3 demonstrates the magnetization *m(T)* data measured for graphite samples intercalated by calcium-ammonia solutions (according to the procedure of Example I) and calcium-strontium-lithium alloys (according to the procedure of Example II). Figure 3a shows ZFC and FC *m(T)* data for Sample 9 exhibiting a superconducting transition at *T_{c}* ≈ 230 K. Sample 9 was prepared by intercalation of graphite (HOPG) by saturated Ca-NH₃ solution (excess Ca) at -90 °C < *T* < -50 °C for an hour. Figure 3b shows ZFC and FC *m(T)* data for Sample 10 exhibiting a superconducting transition at higher *T_{c}* ≈ 269 K. Sample 10 was synthesized by intercalation of graphite (SGL) by lithium-calcium-strontium alloy of 20Li:2Ca:1Sr atomic ratio at *T* = 350 °C for 60 seconds. Figure 3c shows ZFC and FC *m(T)* data for Sample 11 demonstrating a superconducting transition at *T_{c}* ≈ 345 K. Sample 11 was synthesized by intercalation of graphite (SGL) by lithium-calcium-strontium alloy of 20Li:2Ca:1Sr atomic ratio at *T* = 200 °C for 10 minutes. Zoomed regions of *m(T)* data measured for Samples 9 and 10 under FC protocol (the Meissner effect) are shown on top in panels in Figure 3a and Figure 3b. Figures 3d-h show several photos of graphite samples intercalated by Li-Ca alloys (Figures 3d-f) and Ca-NH₃ solutions (Figures 3g and 3h). Samples shown in photos of Figures 3d, 3e, and 3h were synthesized using SGL graphite, whereas samples shown in photos Figures 3f and 3g were synthesized using HOPG graphite. The photo of Figure 3d shows the intercalated sample cut perpendicular to carbon layers, while the rest photos show the intercalated samples cut along carbon layers.

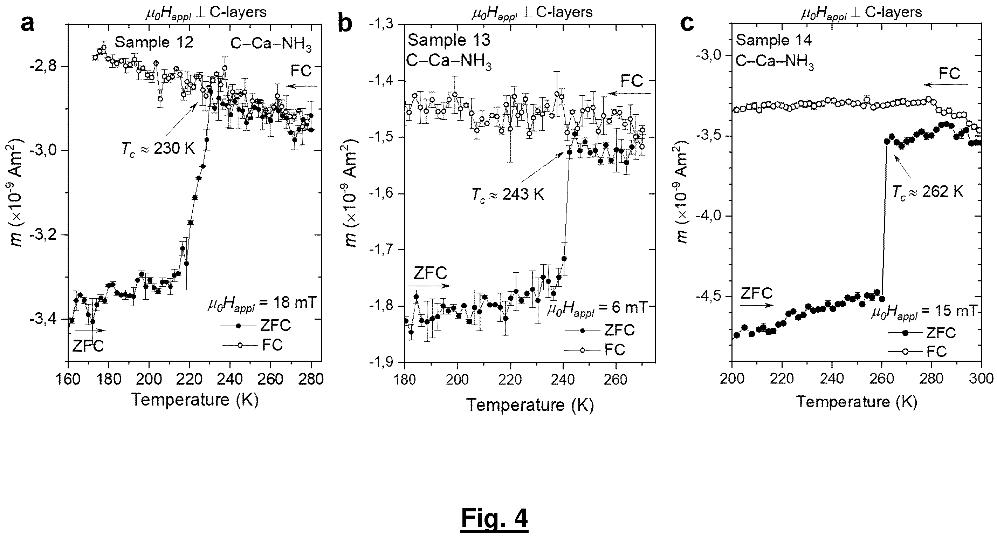

Various samples prepared by intercalation of graphite by Ca-NH₃ solutions exhibited *T_{c}* of superconducting transitions ranging from approximately 230 K to 262 K (see Figure 4).

Figure 4 demonstrates magnetization *m(T)* measurements of graphite samples intercalated by calcium-ammonia solutions. Figure 4a shows ZFC and FC *m(T)* data for Sample 12, synthesized form graphite (HOPG) and saturated Ca-NH₃ solution at *T≈* -70 °C for an hour with subsequent vacuum drying at *T* ≈ -70 °C for 40 minutes and during warming up to room temperature for more 25 minutes, demonstrating *T_{c}* ≈ 230 K. Figure 4b shows ZFC and FC *m(T)* data for Sample 13, synthesized form graphite (HOPG) and saturated Ca-NH₃ solution at *T* ≈ -70 °C for 2.5 hours with subsequent vacuum drying for removing excess NH₃, demonstrating *T_{c}* ≈ 243 K. Figure 4c shows ZFC and FC *m(T)* data for Sample 1, synthesized form graphite (HOPG) and saturated Ca-NH₃ solution at *T* ≈ -70 °C for an hour with subsequent vacuum drying for removing excess NH₃, demonstrating *T_{c}* ≈ 262 K. Applied magnetic fields were perpendicular to carbon layers in samples shown in Figures 4a to 4c.

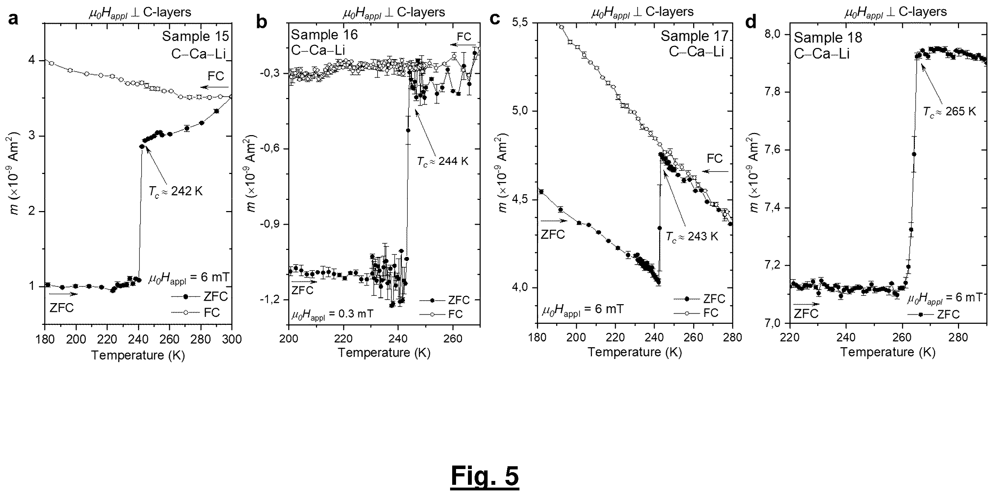

The alternative method of the synthesis by using liquid binary Ca-Li metal alloys for the intercalation of graphite provided samples with *T_{c}* values ranging from approximately 240 K to 265 K (see Figure 5), which are close to the values measured for the graphite-Ca-NH₃ system. Varying the synthesis conditions, we found that graphite samples intercalated by Ca-Li alloys at temperature of 350 °C and 450 °C exhibited transitions with *T_{c}* values of approximately 240 K. Lower temperatures of the intercalation process, *T* = 200 °C, were favorable for products with higher *T_{c}* values above 265 K.

Figure 5 shows magnetization *m(T)* measurements of graphite samples intercalated by binary calcium-lithium alloys. Figure 5a shows ZFC and FC *m(T)* data for Sample 15 exhibiting a superconducting transition at *T_{c} ≈* 242 K. Sample 15 was synthesized by intercalation of graphite (SGL) by Li-Ca alloy of 3.5Li:1Ca atomic ratio at T= 350 °C for 10 minutes. Figure 5b shows ZFC and FC *m(T)* data for Sample 16 exhibiting a superconducting transition at *T_{c}* ≈ 244 K. Sample 16 was synthesized by intercalation of graphite (SGL) by Li-Ca alloy of 20Li:1Ca atomic ratio at *T* = 350 °C for 30 seconds. Figure 5c shows ZFC and FC *m(T)* data for Sample 17 exhibiting the superconducting transition at *T_{c}* ≈ 243 K. Sample 17 was synthesized by intercalation of graphite (SGL) by Li-Ca alloy of 50Li:1Ca atomic ratio at *T* = 450 °C for 15 seconds. Figure 5d shows ZFC *m(T)* data for Sample 18 exhibiting a superconducting transition at *T_{c}* ≈ 265 K. Sample 18 was synthesized by intercalation of graphite (SGL) by Li-Ca alloy of 20Li:1Ca atomic ratio at *T* = 250 °C for 60 seconds. Applied magnetic fields were perpendicular to carbon layers in samples in Figure 5.

Graphite samples intercalated by ternary Ca-Sr-Li alloys exhibited higher *T_{c}* values. The maximum value of *T_{c}* up to 350 K were observed in graphite samples intercalated by Sr-Ca-Li alloys at further decreasing of intercalation temperature down to 150-200 °C. Importantly, *T_{c}* can even exceed 350 K, but this fact becomes an obstacle for the study because the used standard research instrumentation (SQUID magnetometer) was not designed for such high temperatures (see Figure 1c).

### 2. Magnetic field dependence of superconducting transitions.

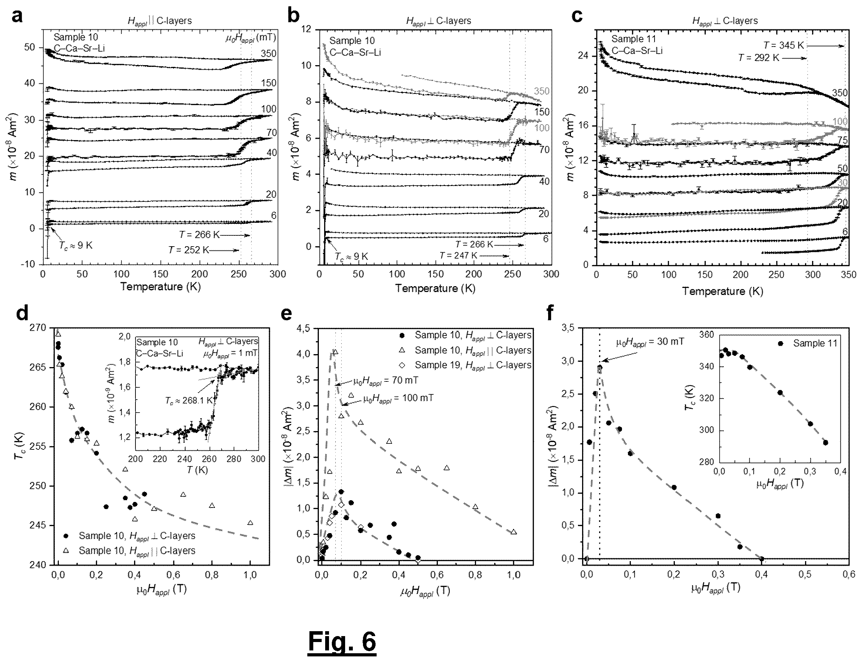

To minimize the magnetic contribution of non-superconducting phases in the samples, instead the standard *m(H)* measurements a series of *m(T)* measurements was performed at different applied magnetic fields, *Hₐₚₚₗ.* This allows to directly extract diamagnetic effect Δ*m* of superconducting transitions as a function of *Hₐₚₚₗ.* In addition, magnetization measurements were conducted in two different orientations of a sample: when *Hₐₚₚₗ* is parallel (*Hₐₚₚₗ* ∥ C-layers) and perpendicular (*Hₐₚₚₗ* ⊥ C-layers) to carbon layers. The summarized magnetization *m(H,T)* data of novel graphite intercalation compounds demonstrate characteristic behaviour for type II superconductors indicating the presence of the mixed superconducting state (see Figure 6).

Figure 6 shows magnetic field dependence of superconducting transitions in graphite samples intercalated by calcium-strontium-lithium alloys. *m(T)* data were measured for Sample 10 at different applied magnetic fields in two different orientations of the sample: *Hₐₚₚₗ* is parallel to carbon layers (see Figure 6a); and *Hₐₚₚₗ* is perpendicular to carbon layers (see Figure 6b). *m(T)* data of Sample 10 indicate the second superconducting transition at *T_{c}* ≈ 9 K in the concomitant CaC₆-like phase²⁶. This low-temperature superconductivity becomes suppressed above 5 K (the lowest temperature in the experiment) at µ₀*Hₐₚₚₗ* = 350 mT. Figure 6c demonstrates *m(T)* data measured for Sample 11 at different *Hₐₚₚₗ* applied perpendicular to carbon layers. Gray dotted lines indicate the shift of the *T_{c}* measured at µ₀*Hₐₚₚₗ* = 6 mT and 350 mT. Figure 6d shows the shift of *T_{c}* with increasing magnetic field in Sample 10. *T_{c}* is defined as the crossing point of two linear fits to the *m(T)* data above *T_{c}* and to the transition part, shown in the inset. Figure 6e shows magnetic field dependence of the change in magnetization, |*Δm*|, of the superconducting transition in graphite samples intercalated by ternary Ca-Sr-Li (Sample 10) and binary Ca-Li (Sample 19). Sample 19 was synthesized by intercalation of graphite (SGL) by lithium-calcium alloy of 20Li:1Ca atomic ratio at T= 350 °C for 60 seconds. |*Δm*| data for Sample 19 was multiplied by factor 2 for a better presentation. Figure 6f shows magnetic field dependence of the change in magnetization, |*Δm*|, of the superconducting transition in Sample 11. The inset in Figure 6f shows the shift of *T_{c}* induced by increase of magnetic fields. Dashed curves are guides for eye.

Increase of applied magnetic fields leads to the shift of *T_{c}* to lower temperatures - an intrinsic property of a superconductor (see Figures 6d and 6f). Additionally, increasing applied magnetic fields leads to the broadening of superconducting transitions, which is more pronounced when *Hₐₚₚₗ* ∥ C-layers.

Using the *m(T)* datasets measured at different applied magnetic fields we plot the dependency of *Δm* versus *Hₐₚₚₗ* in Figures 6e and 6f. These plots represent the behaviour of virgin curves of standard *m(H)* magnetization measurements of a sample cooled under ZFC conditions. The value of |*Δm*| sharply increases with the magnetic field reaching the maximum value at µ₀*Hₐₚₚₗ* ≈ 70 mT (*Hₐₚₚₗ* ∥ C-layers) in Sample 10, and µ₀*Hₐₚₚₗ* ≈ 100 mT (*Hₐₚₚₗ* ⊥ C-layers) in Sample 10 and 19, and µ₀*Hₐₚₚₗ* ≈ 30 mT (*Hₐₚₚₗ* ⊥ C-layers) in Sample 11. Upon further increase of *Hₐₚₚₗ,* |*Δm*| continuously decreases and finally disappears. The observed behaviour is typical for type II superconductors and is explained by entering of vortexes into the sample in the mixed superconducting state, which reduces the screening of applied magnetic fields by the Meissner state. The values of *Hₐₚₚₗ* at which |*Δm*| reaches its maximum values can serve as upper estimations for the penetration field *Hₚ*, above which magnetic field starts to penetrate the superconducting sample.

### 3. Trapping of magnetic flux.

In addition to conventional *m(T)* and *m(H)* magnetization measurements, the trapping of magnetic flux was investigated - another hallmark of superconductivity^{27,28}. The trapped magnetic flux method was found effective in the probing of superconductivity and estimation of superconducting characteristics in high-*T_{c}* hydrogen-rich compounds under high pressures²⁹ and other superconductors at atmospheric pressure^{30,31}.

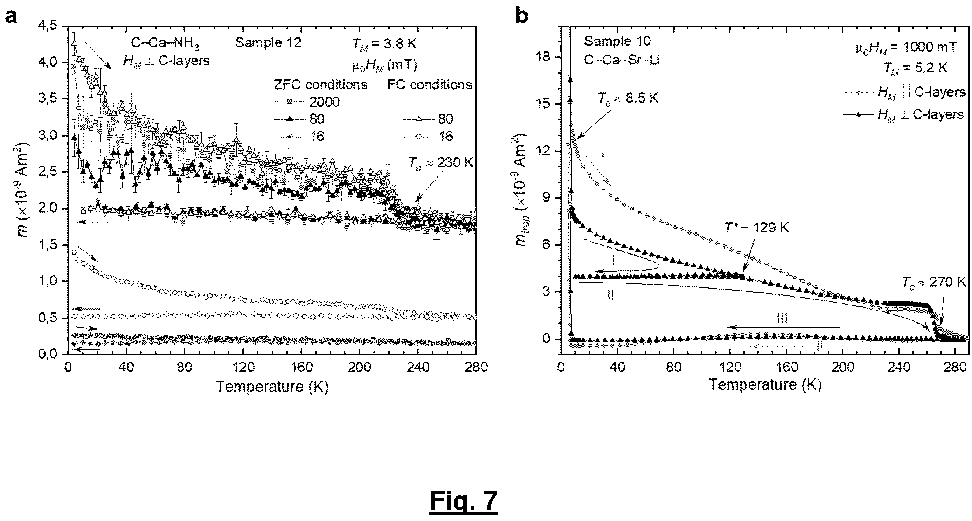

The trapped flux appears due to the presence of superconducting persistent currents in a superconductor after exposing it to magnetic fields. The positive induced magnetic moment, *mₜᵣₐₚ,* decreases upon warming the sample and disappears above *T_{c}.* Figure 7 shows trapped flux measurements in graphite samples intercalated by Ca-NH₃ solutions (Sample 12) and Ca-Sr-Li alloys (Sample 10). The temperature dependence of the trapped magnetic moment, *mₜᵣₐₚ*(*T*), shows clear steps at approximately 230 K in Sample 12 and at approximately 270 K in Sample 10, which is in good agreement with *T_{c}* values derived from conventional *m(T)* magnetization measurements. Measured *mₜᵣₐₚ* values in Sample 10 are significantly higher when the magnetic field at the magnetization step was applied parallel to carbon layers than when *H_{M}* ⊥ C-layers. This agrees well with the difference in Δ*m* values at the superconducting transition extracted from *m(T)* magnetization data collected at different orientations of the sample relative to *Hₐₚₚₗ* (see Figure 6e).

Figure 7 shows the trapping of magnetic flux by superconducting phases in graphite samples intercalated by calcium-ammonia solution and calcium-strontium-lithium alloy. Figures 7a and 7b show the change of the induced magnetic moment versus temperature in Sample 12, synthesized from graphite (HOPG) and saturated Ca-NH₃ solution (excess Ca) at *T* ≈ -70 °C for an hour, and Sample 10, respectively. Trapping of magnetic flux in Sample 12 was generated at temperature of magnetization *T_{M} =* 3.8 K and µ₀*H_{M}* = 16 mT and 80 mT under FC protocol and at µ₀*H_{M} =* 16 mT, 80 mT, and 2 T under ZFC protocol. Trapping of magnetic flux in Sample 10 was generated at µ₀*H_{M}* = 1 T and *T_{M} =* 5.2 K under ZFC protocol for two different orientations of the sample relative to *H_{M}.* The sharp upturn of *mₜᵣₐₚ* below *T* ≈ 8.5 K in Sample 10 stems from the trapped magnetic flux in the concomitant CaC₆-like superconducting phase. Black and gray arrows indicate the direction of temperature change in experiments (cooling and warming cycles). The data measured at reverse cooling the sample from temperature *T > T_{c}* demonstrate almost temperature-independent background of samples after disappearance of the trapped magnetic flux in the normal state. For clarity, the linear background was subtracted from the data measured for Sample 10 (*m* = 6.45×10⁻⁹ + 9.37×10⁻¹³ ×Tfor the data obtained when *Hₘ* ⊥ C-layers; m = 2.41×10⁻⁸ - 5.46×10⁻¹³ ×*T* for the data obtained when *H_{M}* ∥ C-layers).

Importantly, the characteristic behaviour of the trapped magnetic moment generated under ZFC and FC protocols strongly confirms type II superconductivity. In ZFC protocol, the sample is cooled down from *T > T_{c}* to the target temperature, *T_{M},* below *T_{c}* in zero applied magnetic field. At the magnetization step when a magnetic field *H_{M}* is applied and then removed at *T_{M},* magnetization does not occur until *H_{M}* exceeds the penetration field, *Hₚ.* On the contrary, a superconductor cooled from *T* > *T_{c}* to *T_{M}* at magnetic fields (FC mode) traps magnetic flux even if *H_{M}* is lower than *Hₚ* because magnetic flux penetrates a superconductor already at *T* > *T_{c}* and remains in cores of pinned vortexes on further cooling below *T_{c}.* Consequently, the values of *mₜᵣₐₚ* are systematically higher under FC protocol than under ZFC protocol at the same values of *H_{M}* until the trapped magnetic moment saturates (see details of the method in Ref.²⁹).

In Sample 12, the value of the trapped magnetic moment generated under FC protocol at µ₀*H_{M}* = 16 mT is almost one magnitude larger than that generated under ZFC protocol. The difference is smaller at µ₀*H_{M}* = 80 mT, *mₜᵣₐₚ*(FC) is approximately two times larger than *mₜᵣₐₚ*(ZFC)*.* Further increase of µ₀*H_{M}* up to 2 T yields *mₜᵣₐₚ*(ZFC) values close to those of *mₜᵣₐₚ*(FC, µ₀*H_{M}* = 80 mT) suggesting that *mₜᵣₐₚ*(*H_{M}*) becomes saturated, and the full penetration field, H*, lies in a vicinity of 80 mT.

In addition, the behaviour of *mₜᵣₐₚ(T)* in Sample 10 with trapped magnetic flux was examined, which had lost part of its induced magnetic moment upon warming to an intermediate temperature *T*=* 129 K below *T_{c},* i.e., *T_{M} < T** < *T_{c}.* As the temperature was swept below *T*,* superconducting vortexes remain preserved, and *mₜᵣₐₚ(T)* shows almost independent of temperature variation during subsequent cooling and warming cycles within the range of 10-129 K (see Figure 7b). The subtle dissipation of *mₜᵣₐₚ(T)* observed during the temperature cycling is likely attributed to the thermally activated creep of superconducting vortices.

This experiment clearly confirms that the observed induced magnetic moment in the magnetized samples is rather of superconducting origin than resulting from the hypothetical intrinsic magnetism. If intrinsic magnetism were the case, a plateau when cycling from 129 K to 10 K and back would not be observed. Instead, the original trend seen during the initial warming from 5 K to 129 K would repeat. This unique behaviour of *mₜᵣₐₚ(T)* was first observed in study of superconducting hydrogen-rich compounds under high pressures²⁹ and was recently demonstrated in superconducting Sn-Pb alloys at atmospheric pressure³¹.

### 4. Pinning and thermally activated motion of vortices.

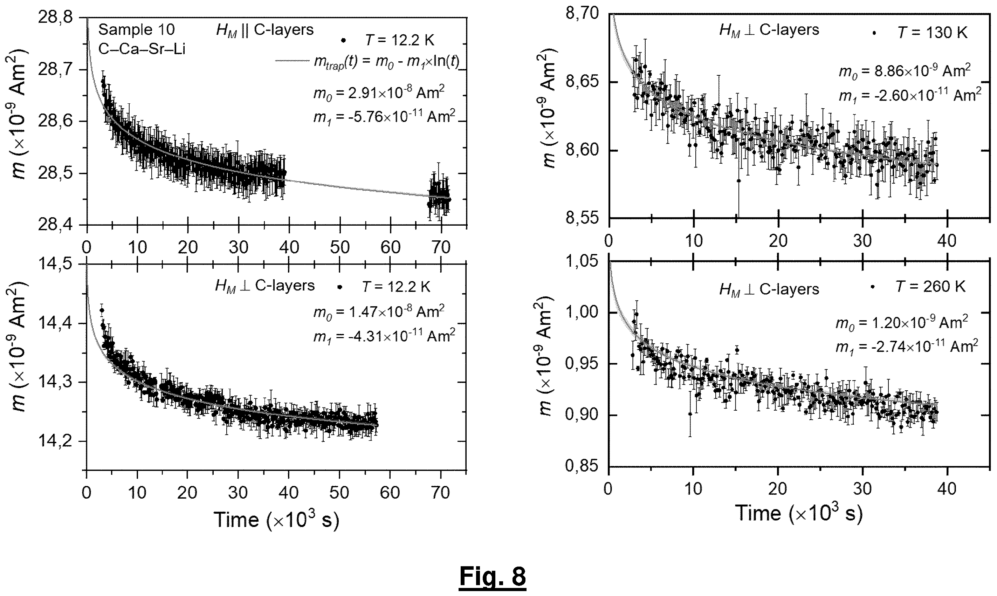

Thermally activated motions of vortices in the mixed state of superconductors enable them to jump out (creep). Consequently, this process leads to dissipation of persistent superconducting currents and decay of the trapped magnetic moment, which can be easily measured in SQUID magnetometer. The time dependence of *mₜᵣₐₚ* generated in Sample 10 under ZFC protocol at µ₀*H_{M}* = 1 T and *T_{M} =* 12.2 K in two different orientations of the sample relative to the applied magnetic field demonstrate low decay rate within up to 20 hours of measurements. The measured *mₜᵣₐₚ(t)* data were fitted by a simple equation with logarithmic time dependence *mₜᵣₐₚ(t) = m₀ - m₁*×ln(*t*) (see Figure 8).

The creep, *S*, can be estimated as $S = - \frac{1}{{m}_{trap , 0}} \frac{{dm}_{trap}}{d ln t}$. We used *m_{trap,0}*(*T =* 12.2 K) ≈ 7.51×10⁻⁹ Am² when *Hₐₚₚₗ* ⊥ C-layers and *m_{trap,0}*(*T =* 12.2 K) ≈ 11.72×10⁻⁹ Am² when *Hₐₚₚₗ* ∥ C-layers, both estimated from *mₜᵣₐₚ(T)* trapped flux measurements. Thus, the estimated values of *S*(*Hₐₚₚₗ* ⊥ C-layers) ≈ 0.006 and *S*(*Hₐₚₚₗ* ∥ C-layers) = 0.005 at *T* = 12.2 K for Sample 10.

*mₜᵣₐₚ*(*t*) datasets were also measured at higher temperatures 130 K and 260 K. Applying the same approach *S*(*Hₐₚₚₗ* ⊥ C-layers) ≈ 0.007 at *T* = 130 K and *S*(*Hₐₚₚₗ* ⊥ C-layers) ≈ 0.013 at *T* = 260 K were obtained.

Figure 8 shows the time dependency of trapped magnetic moment at T = 12.2 K, 130 K, and 260 K. Trapped magnetic flux was created in Sample 10 at µ₀H_{M} = 1 T and T = 12.2 K under ZFC protocol with two different orientations of the sample relative to the applied magnetic field (black circles): when *H_{M}* is parallel (upper panel) and perpendicular to carbon layers (lower panel). *mₜᵣₐₚ(t)* datasets were also measured at higher temperatures, *T =* 130 K and *T* = 260 K. For these measurements trapped flux were generated at µ₀*H_{M}* = 1 T, and *T* = 130 K and *T* = 260 K under ZFC protocol, respectively. Error bars represent the standard deviation of the mean value averaged over three independent measurements. Gray curves are fits of experimental data by equation *mₜᵣₐₚ(t) = m₀- m₁*×ln(*t*)*.*

### 5. Four-probe electrical resistance measurements.

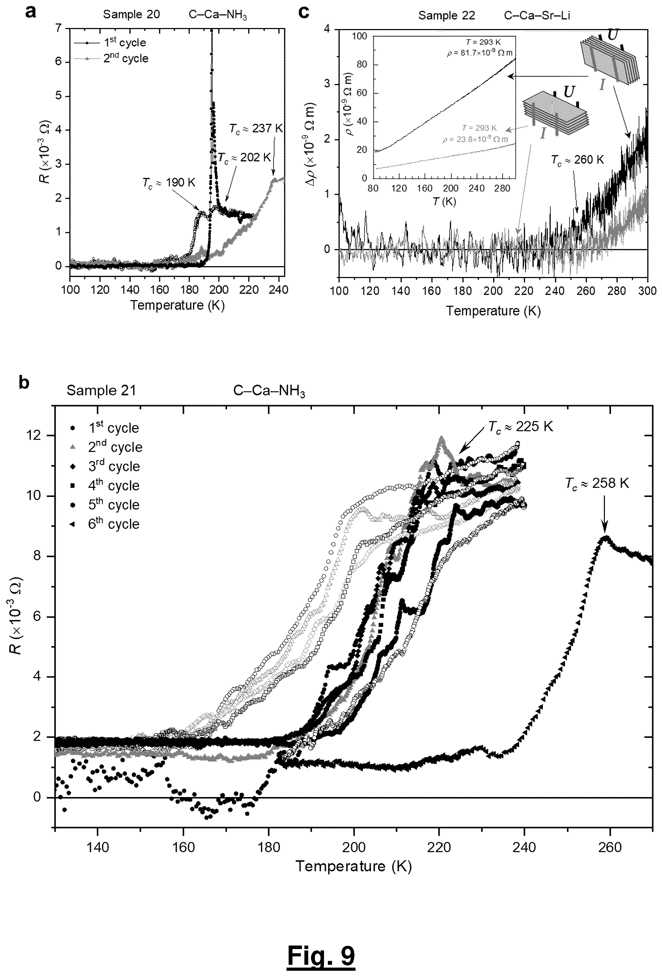

Additionally, electrical resistance measurements were performed - an independent and complementary experimental technique to magnetization measurements for confirmation of superconductivity in graphite samples intercalated by metal-ammonia solutions and lithium-based metal alloys (results are shown in Figure 9).

Electrical resistance of graphite samples intercalated by Ca-NH₃ solutions (following the protocol of Example I) sharply decreased at a *T_{c},* and afterwards is weakly depended on the temperature upon further cooling (see Figures 9a and 9b). Such behaviour of *R*(*T*) is typical for a superconductor where the sharp step in *R*(*T*) indicates a transition from the normal to the superconducting state. The steps on *R*(*T*) data were reproduced on the warming-cooling cycling. Importantly, we observed an increase of *T_{c}* in successive cooling-warming cycles (see grey triangle curve (2^{nd} cycle) in Figure 9a and black triangle curve (6^{th} cycle) in Figure 9b). This fact suggests that concentration of doping Ca atoms and absorbed ammonia in the graphite matrix may be factors responsible for the variation of *T_{c}* values observed in different samples from the graphite-calcium-ammonia system. It is noteworthy that the setup for in-situ electrical resistance measurements was not perfectly designed for precise temperature reading from the sample, therefore the registered temperature could deviate from the actual temperature of the sample. The uncertainty in temperature was even larger upon cooling, because of faster temperature variation rate in comparison to that in the warming cycle. We estimated the uncertainty in temperature as high as 20 K. Nevertheless, electrical resistance measurements revealed the onset *T_{c}* of resistive transitions in graphite samples intercalated by Ca-NH₃ solutions in the temperature range from approximately 200 K to 260 K. These are in good agreement with the onset temperature of the corresponding transitions registered by magnetic susceptibility measurements (*T_{c}* ≈ 230-260 K). The lower *T_{c}*s observed in first warming/cooling cycles in electrical transport measurements may be caused by higher content of ammonia in samples because the time for pumping out the excess ammonia from intercalated samples was reduced.

Figure 9 shows four-probe electrical resistance measurements of graphite samples intercalated by calcium-ammonia solutions and calcium-strontium-lithium alloys. Figures 9a and 9b show in-situ temperature-dependent four-probe electrical resistance measurements of Sample 20 and Sample 21, respectively. Samples 20 and 21 were synthesized using graphite (HOPG) and Ca-NH₃ solutions. Symbols of different shape correspond to different warming-cooling cycles. Open and filled symbols represent data measured upon cooling and warming the sample, respectively. Figure 9c demonstrates temperature dependent four-probe electrical resistivity measurements of Sample 22 showing anomaly at approximately 260 K. Sample 22 was synthesised using graphite (SGL) and ternary Ca-Sr-Li alloys of 20Li:2Ca:1Sr atomic ratio at *T* = 350 °C during 1 minute. Black and gray curves represent the data measured when current and voltage contacts were parallel and perpendicular to carbon layers in the sample, schematically depicted in the Figure 9c, respectively. The inset demonstrates the original *ρ(T)* data before the subtraction of the linear trend below *T_{c}.*

Temperature dependent four-probe electrical resistance measurements of graphite sample intercalated by Ca-Sr-Li alloys (Sample 22) were performed in two configurations of excitation current (*I* = 1 mA) and voltage electrodes showed anomaly in a metallic trend above approximately 260 K (see Figure 9c). For both configurations *ρ(T)* data revealed typical features of a good metal with low electrical resistivity. At 293 K *ρ* = 2.38×10⁻⁸ Ωm parallel to carbon layers and *ρ* = 8.17×10⁻⁸ Ωm perpendicular to carbon planes. These values are significantly lower than the corresponding anisotropic values for pyrolytic graphite (9.8×10⁻⁸ Ωm and 4.1×10⁻⁵ Ωm for two orientations) and are comparable with *ρ* of lithium (9.3×10⁻⁸ Ωm) and aluminum (2.9×10⁻⁸ Ωm). *ρ(T)* of Sample 22 in the temperature range of 80-110 K follows a power-law dependence, which is characteristic for metals at low temperatures. Above approximately 110 K, *ρ* increases linearly with temperature up to approximately 250-260 K. Above this range, an anomaly is observed as a steady deviation from the classical linear trend. Subtracting the linear portion of resistivity from the measured *ρ(T)* data enhances the visualization of this anomalous behavior, which is not typical for a metal at high temperatures (see Figure 9c). Notably, this anomaly aligns well with the observed transitions in graphite samples intercalated by ternary Ca-Sr-Li alloys by various magnetization measurements.

### Discussions

To prepare the above shown data, more than hundreds of samples using either Ca-NH₃ solutions or Li-based metal alloys were synthesized and probed. Superconductivity was detected in approximately 80% samples from the C-Ca(Sr)-Li system, while the success rate was about 50% for the C-Ca-NH₃ system likely because of fast degradation of samples during the handling due to high reactivity of metal-ammonia solutions. Various magnetization and electrical resistance measurements were performed. The obtained results support superconducting nature of the observed transitions. The characteristic indications of high-temperature superconductivity above 200 K appear only in the intercalated graphite samples but not in the used pristine graphite sources.

The fact, that different synthetic routes used for intercalation of graphite resulted in products with similar *T_{c}* values of the observed transitions indicates that Li in metal alloys and NH₃ in metal-ammonia solutions primarily plays a role of a carrier for doping metals into graphite matrix. Both Li and NH₃ readily dissolve the doping Ca and some other metals at temperatures significantly lower than melting points of these metals and facilitates the intercalation process. The doping of graphite matrix by a proper doping metal is the key factor for the immergence of superconductivity. However, it cannot be excluded that both Li and NH₃ can induce secondary favourable effects in these materials such as changes in interlayer distances and C-C covalent bond lengths in the pristine graphite.

Unlike Ca-NH₃ solutions, intercalation of graphite by Ca(Sr)-Li alloys can result in the formation of concomitant low-temperature superconducting phase(s). The observed *T_{c}*s lying in a temperature range of approximately 7-11.5 K are close to the values reported for CaC₆³² and Ca₂Li₃C₆¹⁹ compounds. Both compounds were reported to form through the intercalation of graphite by binary Ca-Li alloys at similar conditions of the synthesis: nearly single-phase CaC₆ and Ca₂Li₃C₆ samples were obtained after 10 days of the synthesis at *T* = 350 °C³² and *T* = 250-300 °C¹⁹, respectively.

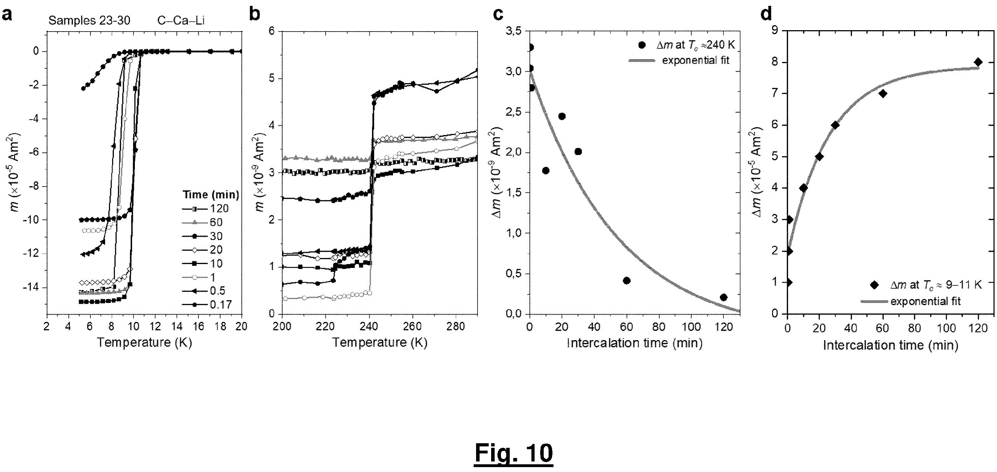

Importantly, the concomitant low-temperature superconducting phases in the graphite samples intercalated by Ca(Sr)-Li alloys are not responsible for the high-temperature superconductivity in these samples. On the contrary, it was found that increasing of the intercalation time leads to the growth of the low*-T_{c}* phase and disappearance of the high-*T_{c}* superconductivity (see Figure 10). In addition, the samples intercalated by Li-based alloys not containing Ca metal (e.g., Sr, Mg, and Zn) also exhibited high-*T_{c}* transitions (see below).

Figure 10 shows magnetization *m(T)* measurement results of graphite samples intercalated by binary calcium-lithium alloys for different time. Figures 10a and 10b show ZFC *m(T)* data for samples of graphite intercalated by binary Ca-Li alloy at different time of the synthesis (Samples 23-30), showing two superconducting transitions in the low-temperature phase at *T_{c}* ≈ 9-11 K and high-temperature phase at *T_{c}* ≈ 240 K. Samples 23-30 were synthesized by intercalation of graphite (SGL) samples with Li-Ca alloy of 3.5Li:1Ca atomic ratio at *T* = 350 °C varying the intercalation time form 10 seconds to 120 minutes. Figures 10c and 10d show the dependence of the observed *Δm* at the superconducting transitions in the low*-T_{c}* (see Figure 10a) and high-*T_{c}* (see Figure 10b) phases versus intercalation time. Solid line represents the exponential fit of experimental data. Applied magnetic fields were perpendicular to carbon layers in samples.

The decrease of the content of the high-*T_{c}* superconducting phase upon the increase of intercalation time in the C-Ca-Li system supports the idea that the high-temperature superconductivity immerges in the phase with lower doping rate compared to the low*-T_{c}* CaC₆-like phase.

Short intercalation times are favorable for graphite intercalation compounds of higher stages preceding the fully intercalated phases (e.g., CaC₆). The higher stage the greater separation between the intercalated graphite layers. This intriguing arrangement leads to lowering of dimensionality in the product and might be favorable for the observed high-*T_{c}* superconductivity. For example, the lowering of dimensionality in Li-³³ and K-doped³⁴ few-layers-graphene resulted in increase of observed *T_{c}*s in comparison to bulky LiC₆ and KC₈ compounds, however the shift is not so dramatic as observed in the present study.

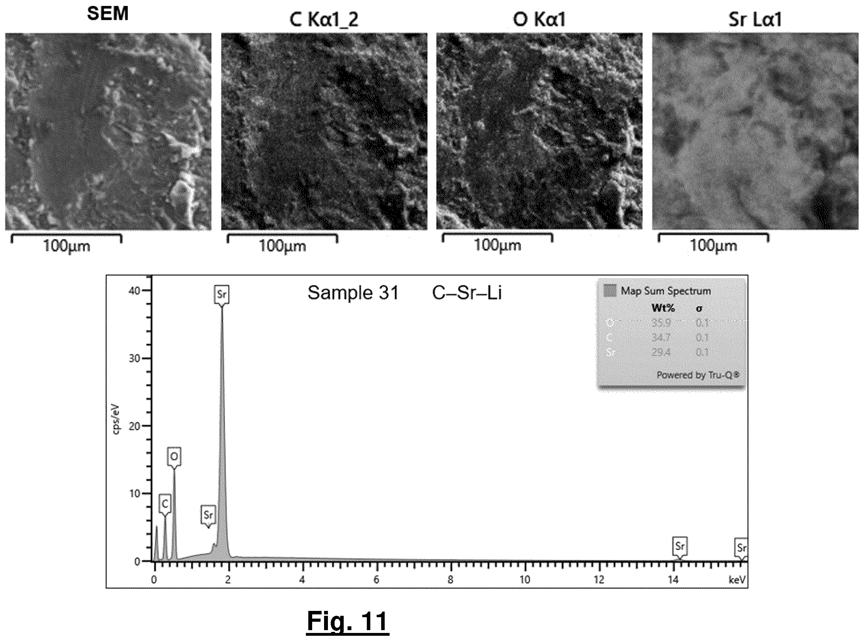

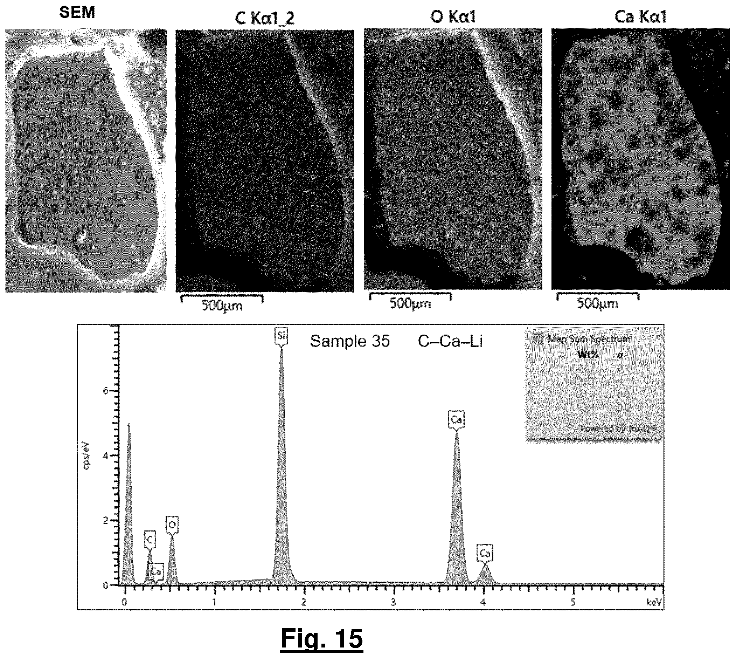

The results of energy dispersive X-ray (EDX) analysis confirmed much lower concentration of the dopants in graphite samples intercalated by lithium-based alloys for short times (few minutes, see Figures 11-14) in comparison to that intercalated for longer time (tens of hours, see Figure 15). Taking into account a high content of oxygen in the analyzed samples exposed at the air during handling (few minutes), the estimated amount of the lithium is much higher than that in LiC₆ compound, suggesting that many-layers of intercalated Li metal can be realized between two carbon layers similar to that found in Ca₂Li₃C₆ compounds¹⁹.

EDX analysis of pristine graphite samples (HOPG and SGL samples), i.e., prior to subjecting them to intercalation treatments, are shown in Figures 16 and 17 and confirms their purity claimed by manufacturers.

Figure 11 shows energy dispersive X-ray analysis of the graphite intercalated by binary Li-Sr alloy (sample 31). Top: scanning electron microscope image of the analyzed surface and colored maps showing the distribution of the determined elements. Bottom: EDX spectrum. The sample was synthesized by intercalation of graphite (SGL) by Li-Sr alloy of 3Li:1Sr atomic ratio at *T* = 350 °C for 1 minute. The surface was cut parallel to carbon layers at a half of the thickness of the synthesized sample. The analysis revealed the presence of doping Sr atoms intercalated into graphite. Sr content amounts approximately 6.1 atomic percent. The C:Sr:O ratio suggests the composition of SrC_{8.6} and the derived Li:Sr atomic ratio of 11.4:1, assuming that Li and Sr were completely oxidized to Li₂O and SrO.

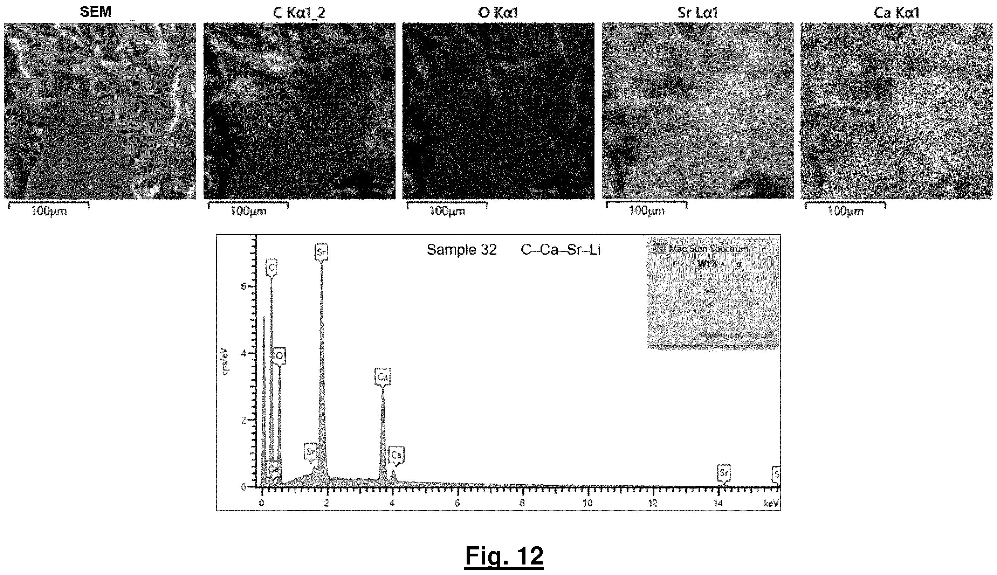

Figure 12 shows energy dispersive X-ray analysis of the graphite intercalated by ternary Li-Ca-Sr alloy (sample 32). Top: scanning electron microscope image of the analyzed surface and colored maps showing the distribution of the determined elements. Bottom: EDX spectrum. The sample was synthesized by intercalation of graphite (SGL) by Li-Ca-Sr alloy of 20Li:1Ca:1Sr atomic ratio at *T* = 150 °C for 1 minute. The surface was cut parallel to carbon layers at a half of the thickness of the synthesized sample. The analysis revealed the presence of both doping Ca and Sr atoms intercalated into graphite. Ca and Sr content amounts approximately 2.1 and 2.5 atomic percent, respectively. The C:Ca:Sr:O ratio suggests the composition of Ca₁Sr_{1.2}C_{31.6} and the derived Li:Ca:Sr atomic ratio of 22.6:1:1.2, assuming that Li, Ca, and Sr were completely oxidized to Li₂O, CaO, and SrO.

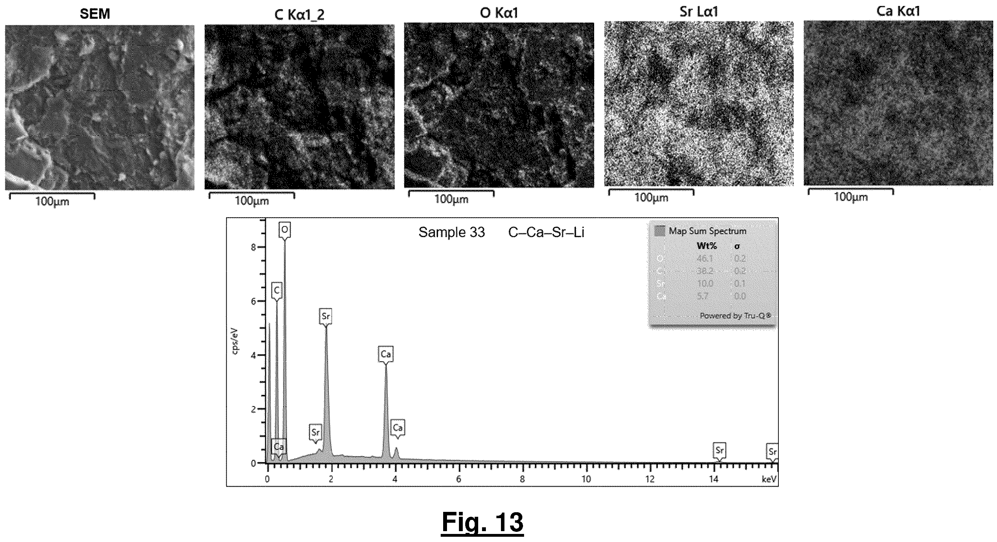

Figure 13 shows energy dispersive X-ray analysis of the graphite intercalated by ternary Li-Ca-Sr alloy (sample 33). Top: scanning electron microscope image of the analyzed surface and colored maps showing the distribution of the determined elements. Bottom: EDX spectrum. The sample was synthesized by intercalation of graphite (SGL) by Li-Ca-Sr alloy of 20Li:1Ca:1Sr atomic ratio at *T* = 250 °C for 1 minute. The surface was cut parallel to carbon layers at a half of the thickness of the synthesized sample. The analysis revealed the presence of both doping Ca and Sr atoms intercalated into graphite. Ca and Sr content amounts approximately 2.7 and 2.1 atomic percent, respectively. The C:Ca:Sr:O ratio suggests the composition of Ca₁Sr_{0.8}C_{22.4} and the derived Li:Ca:Sr atomic ratio of 22.8:1:0.8, assuming that Li, Ca, and Sr were completely oxidized to Li₂O, CaO, and SrO.

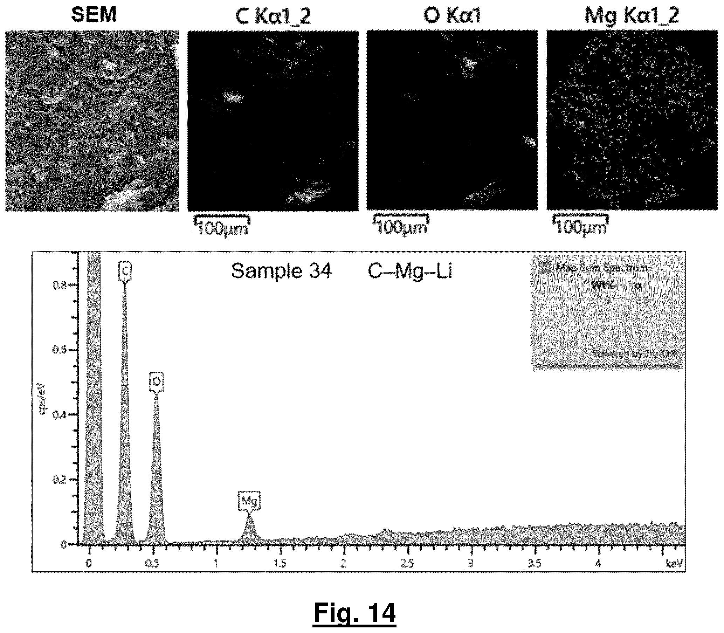

Figure 14 shows energy dispersive X-ray analysis of the graphite intercalated by binary Li-Mg alloy (sample 34). Top: scanning electron microscope image of the analyzed surface and colored maps showing the distribution of the determined elements. Bottom: EDX spectrum. The sample was synthesized by intercalation of graphite (SGL) by Li-Mg alloy of 4Li:1Mg atomic ratio at *T* = 350 °C for 5 minutes. The surface was cut parallel to carbon layers at a half of the thickness of the synthesized sample. The analysis revealed the presence of doping Mg atoms intercalated into graphite. Mg content amounts approximately 1.1 atomic percent. The C:Mg:O ratio suggests the composition of Mg₁C_{55.5} and the derived Li:Mg atomic ratio of 72:1, assuming that Li and Mg were completely oxidized to Li₂O and MgO.

Figure 15 shows energy dispersive X-ray analysis of the graphite intercalated by binary Li-Ca alloy (sample 35). Top: scanning electron microscope image of the analyzed surface and colored maps showing the distribution of the determined elements. Bottom: EDX spectrum. The sample was synthesized by intercalation of graphite (HOPG) by Li-Ca alloy of 3.5Li:1Ca atomic ratio at T= 350 °C for 91 hours. The surface was cut parallel to carbon layers at a half of the thickness of the synthesized sample and covered by dry silicon oil. The analysis revealed the presence of doping Ca atoms intercalated into graphite. Ca content amounts approximately 9.9 atomic percent. The C:Ca:O ratio suggests the composition of CaC_{4.2} and the derived Li:Ca atomic ratio of 3.0:1, assuming that Li and Ca were completely oxidized to Li₂O and CaO and the Si:O ratio in the used silicon oil is 1:1.

Figure 16 shows energy dispersive X-ray analysis of the pristine graphite source (HOPG) (sample 36). Top: scanning electron microscope image of the analyzed surface and maps showing the distribution of the determined elements. Bottom: EDX spectrum. The surface was cut parallel to carbon layers at a half of the thickness of the used material. The sample underwent the standard treatment prior the analysis: annealing at *T* = 450 °C in Ar-H₂ flow (5 % of H₂) for 2 hours. The analysis confirmed the claimed high purity of the pristine graphite material.

Figure 17 shows energy dispersive X-ray analysis of the pristine graphite source (SGL) (sample 37). Top: scanning electron microscope image of the analyzed surface and maps showing the distribution of the determined elements. Bottom: EDX spectrum with the zoomed area of interest, showing the peaks from impurity elements. The surface was cut parallel to carbon layers at a half of the thickness of the used material. The sample underwent the standard treatment prior the analysis: annealing at *T* = 450 °C in Ar-H₂ flow (5% of H₂) for 2 hours. The analysis revealed impurities of phosphorus and sulfur in the material, which stem from the technological process of compacting the material. The both P and S impurities amount approximately 0.04 atomic percent.

Graphite samples intercalated by metal alloys (following the protocol of Example II) and then treated in ethanol or isopropanol bathes, which led to the deintercalated surface, still exhibited high-temperature superconductivity. In addition, magnetic susceptibility measurements of the internal part (about 50 vol. %) of the graphite sample intercalated by Li-Ca-Sr alloy (Li:Ca:Sr atomic ratio of 20:2:1) confirmed high-temperature superconductivity. This indicates the bulk nature of observed superconductivity rather than surface superconductivity.

An obvious question is whether a further increase of a *T_{c}* and superconducting fraction in these materials are possible. The details presented herein already demonstrate a significant enhancement of a *T_{c}*: the very first measured *T_{c}* of approximately 230 K found in graphite samples intercalated by Ca-NH₃ solutions (preparation following the protocol of Example I) has been drastically increased at least up to 350 K in samples intercalated by ternary Ca-Sr-Li alloys (obtained by applying the protocol of Example II). It is not excluded, that even higher *T_{c}* values in the novel superconductors are available. This can be achieved, for instance, by tuning conditions of the intercalation reaction and varying the host matrix and intercalants. Experiments indicate that high-temperature superconductivity is not limited by Ca-doped systems. Graphite samples intercalated by K-Li, Sr-Li, Mg-Li, Zn-Li, and Mg-Zn-Li alloys also exhibit high-temperature superconductivity (see Table 1 and Figures 2, 18, and 19).

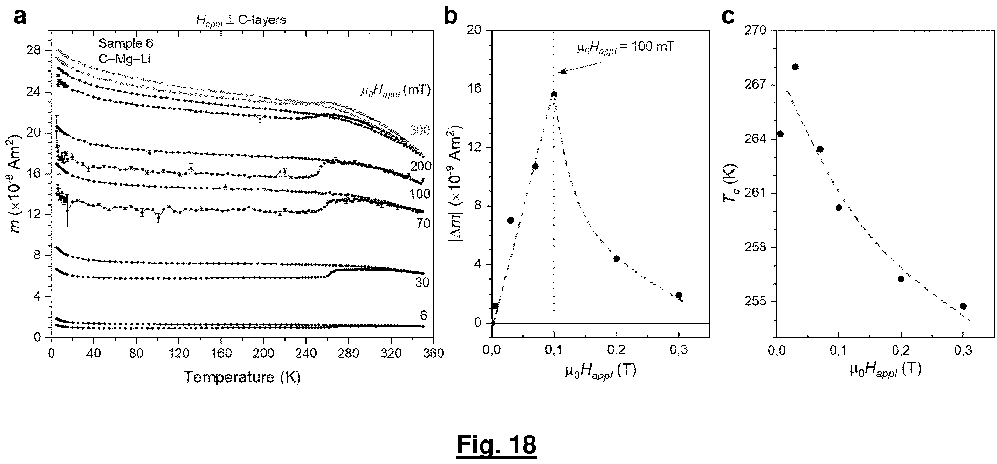

Figure 18 shows magnetic field dependence of superconducting transitions in graphite samples intercalated by magnesium-lithium alloy. Figure 18a shows *m(T)* data measured for Sample 6 at different applied magnetic fields (*Hₐₚₚₗ* is perpendicular to carbon layers). Sample 6 was synthesized by intercalation of graphite (SGL) by lithium-magnesium alloy of 4Li:1Mg atomic ratio at *T* = 350 °C for 5 minutes. Figure 18b shows a magnetic field dependence of the change in magnetization, |*Δm*|, of the superconducting transition in Sample 6. Figure 18c shows a shift of *T_{c}* in applied magnetic fields in Sample 6. Curves are guides for the eye.

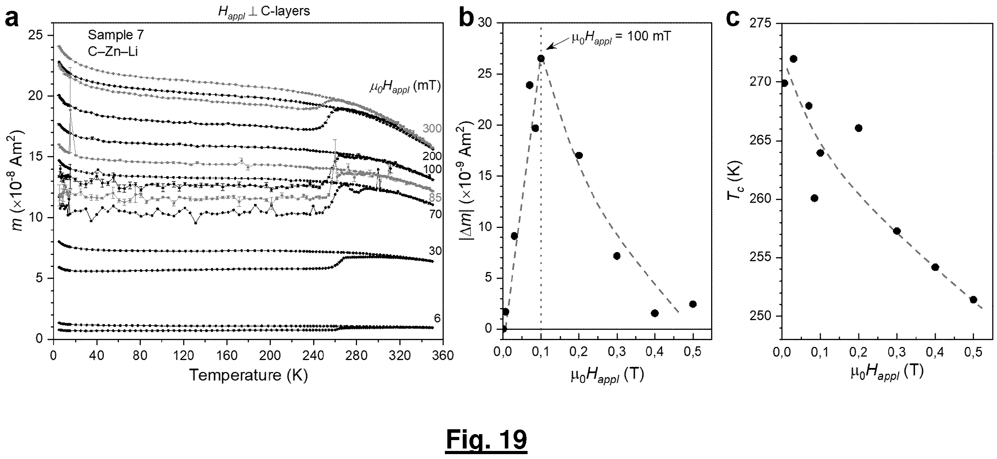

Figure 19 shows magnetic field dependence of superconducting transitions in graphite samples intercalated by zinc-lithium alloy. Figure 19a shows *m(T)* data measured for Sample 7 at different applied magnetic fields (*Hₐₚₚₗ* is perpendicular to carbon layers). Sample 7 was synthesized by intercalation of graphite (SGL) by lithium-zinc alloy of 4Li:1Zn atomic ratio at *T* = 300 °C for 5 minutes. Figure 19b shows a magnetic field dependence of the change in magnetization, |*Δm*|, of the superconducting transition in Sample 7. Figure 19c shows a shift of *T_{c}* in applied magnetic fields in Sample 7. Curves are guides for the eye.

The following Table 2 gives an overview of the samples for which data are shown in the Figures.

**Table 2:**

| Sample Number | Synthesis Protocol | *T_{c}* (K) | Doping Medium | Intercalation Time | Intercalation Temperature | Data shown in |
|---|---|---|---|---|---|---|
| 1 | Example II | 261 | Ca-Sr-Li | 60 seconds | 250 °C | Fig. 1 |
| 2 | Example II | 267-273 | Ca-Sr-Li | 60 seconds | 350 °C | Fig. 1 |
| 3 | Example II | 290, 350 | Ca-Sr-Li | 10 minutes | 200 °C | Fig. 1 |
| 4 | Example II | 240 | K-Li | 30 seconds | 250 °C | Fig. 2 |
| 5 | Example II | 242 | Sr-Li | 60 seconds | 350 °C | Fig. 2 |
| 6 | Example II | 264 | Mg-Li | 5 minutes | 350 °C | Fig. 2, 18 |
| 7 | Example II | 270 | Zn-Li | 5 minutes | 300 °C | Fig. 2, 19 |
| 8 | Example II | 300 | Mg-Zn-Li | 4 minutes | 250 °C | Fig. 2 |
| 9 | Example I | 230 | Ca-NH₃ | 1 hour | -90 °C to -50 °C | Fig. 3 |
| 10 | Example II | 269 | Ca-Sr-Li | 60 seconds | 350 °C | Fig. 3, 6, 7, 8 |
| 11 | Example II | 345 | Ca-Sr-Li | 10 minutes | 200 °C | Fig. 3, 6 |
| 12 | Example I | 230 | Ca-NH₃ | 40 minutes | -70 °C | Fig. 4, 7 |
| 13 | Example I | 243 | Ca-NH₃ | 2.5 hours | -70 °C | Fig. 4 |
| 14 | Example I | 262 | Ca-NH₃ | 1 hour | -70 °C | Fig. 4, 9 |
| 15 | Example II | 242 | Ca-Li | 10 minutes | 350 °C | Fig. 5 |
| 16 | Example II | 244 | Ca-Li | 30 seconds | 350 °C | Fig. 5 |
| 17 | Example II | 243 | Ca-Li | 15 seconds | 450 °C | Fig. 5 |
| 18 | Example II | 265 | Ca-Li | 60 seconds | 250 °C | Fig. 5 |
| 19 | Example II | 248 | Ca-Li | 60 seconds | 350 °C | Fig. 6 |
| 20 | Example I | 202-237 | Ca-NH₃ | 1 hour | -70 °C | Fig. 9 |
| 21 | Example I | 225-258 | Ca-NH₃ | 10 minutes | -70 °C | Fig. 9 |
| 22 | Example II | 260 | Ca-Sr-Li | 1 minute | 350 °C | Fig. 9 |
| 23 | Example II | 240 | Ca-Li | 10 seconds | 350 °C | Fig. 10 |
| 24 | Example II | 240 | Ca-Li | 30 seconds | 350 °C | Fig. 10 |
| 25 | Example II | 240 | Ca-Li | 1 minute | 350 °C | Fig. 10 |
| 26 | Example II | 240 | Ca-Li | 10 minutes | 350 °C | Fig. 10 |
| 27 | Example II | 240 | Ca-Li | 20 minutes | 350 °C | Fig. 10 |
| 28 | Example II | 240 | Ca-Li | 30 minutes | 350 °C | Fig. 10 |
| 29 | Example II | 240 | Ca-Li | 60 minutes | 350 °C | Fig. 10 |
| 30 | Example II | 240 | Ca-Li | 120 minutes | 350 °C | Fig. 10 |

At present it can only be speculated about the mechanism of extraordinary high-temperature superconductivity in the novel graphite intercalation compounds. Superconductivity may occur in a certain crystal phase characterized by specific staging (intercalated layers alter with non-intercalated pristine graphite layers) and concentration of the doping elements. The energy dispersive X-ray analysis of superconducting samples confirms significantly lower content of the doping elements in comparison to the known CaC₆ and Ca₂Li₃C₆ compounds exhibiting *T_{c}* below 12 K. Another possible scenario includes the involvement of structural defects in graphite matrix. Theoretical studies underline that rhombohedral phase of graphite is especially promising for high-*T_{c}* superconductivity due to its topologically protected surface states with flat bands at the Fermi energy³⁵. It was argued that stacking faults and interfaces between different stackings of graphite, including boundaries between inclusions of rhombohedral phase, can result in emergence of flat bands. A proper doping provides high DOS and leads to large coupling constant favouring high-*T_{c}* superconductivity.

Here, we demonstrate the first observations of high-temperature superconductivity with a *T_{c}* significantly exceeding room temperature in the novel graphite intercalation compounds. Further experimental and theoretical studies will elucidate the structure of these materials and the mechanism of superconductivity.

### References

1 Kamerlingh-Onnes, H. On the change of the electrical resistance of pure metals at very low temperatures. Leiden Commun. 120b, 122b, 124c (1911).
2 Srinivas, G. et al. Ammonia absorption in calcium graphite intercalation compound: in situ neutron diffraction, Raman spectroscopy and magnetization. Phys. Chem. Chem. Phys., 12, 6253-6259 (2010).
3 Bednorz, J. G. & Mueller, K. A. Possible High T Superconductivity in the Ba - La - Cu - 0 System. Z. Phys. B - Condensed Matter 64, 189-193 (1986).
4 Schilling, A., Cantoni, M., Guo, J. D. & Ott, H. R. Superconductivity above 130 K in the Hg-Ba-Ca-Cu-O system. Nature 363, 56-58 (1993).
5 Gao, L. et al. Superconductivity up to 164 K in HgBa2Cam-1CumO2m+2+δ (m=1, 2, and 3) under quasihydrostatic pressures. Phys. Rev. B 50 (1994).
6 Drozdov, A. P., Eremets, M. I., Troyan, I. A., Ksenofontov, V. & Shylin, S. I. Conventional superconductivity at 203 K at high pressures. Nature 525, 73 (2015).
7 Kong, P. P. et al. Superconductivity up to 243 K in the yttrium-hydrogen system under high pressure. Nat. Commun. 12, 5075 (2021).
8 Wang, Y. et al. Synthesis and superconductivity in yttrium superhydrides under high pressure. Chinese Physics B 31, 106201 (2022). https://doi.org/10.1088/1674-1056/ac872e
9 Drozdov, A. P. et al. Superconductivity at 250 K in lanthanum hydride under high pressures Nature 569, 528 (2019).
10 Somayazulu, M. et al. Evidence for superconductivity above 260 K in Lanthanum superhydride at megabar pressures. Phys. Rev. Lett. 122, 027001 (2019).
11 Zhong, X. et al. Prediction of above-room-temperature superconductivity in Lanthanide/Actinide extreme superhydrides. J. Am. Chem. Soc. 144, 13394-13400 (2022). https://doi.org/10.1021/jacs.2c05834
12 Sun, Y., Lv, J., Xie, Y., Liu, H. & Ma, Y. Route to a superconducting phase above room temperature in electron-doped hydride compounds under high pressure. Phys. Rev. Lett. 123, 097001 (2019). https://doi.org/10.1103/PhysRevLett.123.097001
13 Cohen, M. L. Superconductivity in modified semiconductors and the path to higher transition temperatures. Supercond. Sci. Technol. 28, 043001 (2015).
14 Ekimov, E. A. et al. Superconductivity in diamond. Nature 428, 542 (2004).
15 Bhaumik, A., Sachan, R., Gupta, S. & Narayan, J. Discovery of High-Temperature Superconductivity (Tc = 55 K) in B-Doped Q-Carbon. ACS Nano 11, 11915-11922 (2017).
16 Tanigaki, K. et al. Superconductivity at 33 K in CsxRbyC60. Nature 352, 222-223 (1991). https://doi.org/10.1038/352222a0
17 T Enoki, Suzuki, M. & Endo, M. Graphite intercalation compounds and applications. (Oxford University Press, 2003).
18 Smith, R. P. et al. Superconductivity in graphite intercalation compounds. Physica C: Superconductivity and its Applications 514, 50-58 (2015).
19 Emery, N. et al. Superconductivity in Li3Ca2C6 intercalated graphite. Journal of Solid State Chemistry 179, 1289-1292 (2006). https://doi.org/https://doi.org/10.1016/j.jssc.2006.01.053
20 Mazin, I. I. et al. Unresolved problems in superconductivity of CaC6. Physica C: Superconductivity and its Applications 460-462, 116-120 (2007).
21 Mazin, I. I. Intercalant-Driven Superconductivity in YbC6 and CaC6. Phys. Rev. Lett. 95, 227001 (2005).
22 Ginzburg, V. L. Once again about high-temperature superconductivity. Contemporary Physics 33, 15-23 (1992). https://doi.org/10.1080/00107519208219137
23 Vitalii, L. G. High-temperature superconductivity (history and general review). Soviet Physics Uspekhi 34, 283 (1991). https://doi.org/10.1070/PU1991v034n04ABEH002361
24 Ashcroft, N. W. Metallic Hydrogen: A High-Temperature Superconductor? Physical Review Letters 21, 1748-1749 (1968). https://doi.org/10.1103/PhysRevLett.21.1748
25 Ashcroft, N. W. Hydrogen Dominant Metallic Alloys: High Temperature Superconductors? Phys. Rev. Lett. 92, 187002 (2004).
26 Emery, N. et al. Superconducting graphite intercalation compounds with calcium. Solid State Sciences 10, 466-470 (2008). https://doi.org/https://doi.org/10.1016/j.solidstatesciences.2007.11.034
27 Pippard, A. B. Trapped flux in superconductors. Phylos. Tranls. Roy. Soc. London. Ser A, 248, 97-129 (1955).
28 Miiller, K. A., Takashige, M. & Bednorz, J. G. Flux Trapping and Superconductive Glass State in LaqCu04 «'.Ba. PRL 58, 1143 (1987).
29 Minkov, V. S., Ksenofontov, V., Budko, S. L., Talantsev, E. F. & Eremets, M. I. Trapped magnetic flux in hydrogen-rich high-temperature superconductors Nature Physics (2023).
30 Bud'ko, S. L., Xu, M. & Canfield, P. C. Trapped flux in pure and Mn-substituted CaKFe4As4 and MgB2 superconducting single crystals. Superconductor Science and Technology 36, 115001 (2023). https://doi.org/10.1088/1361-6668/acf413
31 Mizuguchi, Y., Murakami, T., Kasem, M. R. & Arima, H. Large self-heating by trapped-flux reduction in Sn-Pb solders. Europhysics Letters 147, 36003 (2024). https://doi.org/10.1209/0295-5075/ad6802
32 Emery, N. et al. Superconductivity of Bulk CaC6. Physical Review Letters 95, 087003 (2005). https://doi.org/10.1103/PhysRevLett.95.087003
33 Tiwari, A. P. et al. Superconductivity at 7.4 K in few layer graphene by Li-intercalation. Journal of Physics: Condensed Matter 29, 445701 (2017). https://doi.org/10.1088/1361-648X/aa88fb
34 Huempfner, T., Otto, F., Forker, R., Müller, P. & Fritz, T. Superconductivity of K-Intercalated Epitaxial Bilayer Graphene. Advanced Materials Interfaces 10, 2300014 (2023). https://doi.org/https://doi.org/10.1002/admi.202300014
35 Kopnin, N. B., Ijäs, M., Harju, A. & Heikkilä, T. T. High-temperature surface superconductivity in rhombohedral graphite. Physical Review B 87, 140503 (2013). https://doi.org/10.1103/PhysRevB.87.140503
36 Bale, C. W. & Pelton, A. D. The Ca-Li (Calcium-Lithium) system. Journal of Phase Equilibria 8, 125-127 (1987). https://doi.org/10.1007/BF02873196
37 Bale, C. W. & Pelton, A. D. The Li-Sr (Lithium-Strontium) system. Bulletin of Alloy Phase Diagrams 10, 278-280 (1989). https://doi.org/10.1007/BF02877514
38 Nayeb-Hashemi, A. A., Clark, J. B. & Pelton, A. D. The Li-Mg (Lithium-Magnesium) system. Bulletin of Alloy Phase Diagrams 5, 365-374 (1984). https://doi.org/10.1007/BF02872951
39 Okamoto, H. Li-Zn (Lithium-Zinc). Journal of Phase Equilibria and Diffusion 33, 345-345 (2012). https://doi.org/10.1007/s11669-012-0052-x
40 Kim, J. S., Boeri, L., O'Brien, J. R., Razavi, F. S. & Kremer, R. K. Superconductivity in Heavy Alkaline-Earth Intercalated Graphites. Physical Review Letters 99, 027001 (2007). https://doi.org/10.1103/PhysRevLett.99.027001

## Claims

1. Graphite-based superconducting material having a critical temperature *T_{c}* of 200 K or higher, as determined by four-probe electrical resistance and/or magnetic susceptibility measurements, wherein the graphite-based superconducting material is obtainable by a method comprising the following steps:
Step (A): providing a liquid doping medium comprising a metal, either as a melt or in a solution, and providing graphite;
Step (B): intercalating the metal into the graphite by immersing the graphite in the doping medium provided in step (A) for a time period in the range of 1 second to 4 weeks to obtain a doped graphite, and
Step (C): after step (B), removing the doped graphite from the doping media described in step (A) to obtain the graphite-based superconducting material.

2. Graphite-based superconducting material according to claim 1,
wherein in step (A), the doping medium comprising the metal in a liquid state as a melt, is a mixture of lithium and a metal different from lithium.

3. Graphite-based superconducting material according to claim 1 or 2,
wherein the non-lithium metal is a monovalent or heterovalent to lithium.

4. Graphite-based superconducting material according to any one of the preceding claims,
wherein the non-lithium metal is at least one metal selected from the group consisting of Sodium (Na), Potassium (K), Rubidium (Rb), Cesium (Cs), Beryllium (Be), Magnesium (Mg), Calcium (Ca), Strontium (Sr), Barium (Ba), Zinc (Zn), Cadmium (Cd), Mercury (Hg),Yttrium (Y), Lanthanum (La), Cerium (Ce), Europium (Eu), Titanium (Ti), Scandium (Sc), Niobium (Nb), Vanadium (V), Molybdenum (Mo), Rhenium (Re), Aluminum (Al), Gallium (Ga), Indium (In), Thallium (TI), Tin (Sn), Lead (Pb), Antimony (Sb), Bismuth (Bi) and combinations thereof, preferably selected from the group consisting of K, Ca, Sr, Mg and Zn and combinations thereof, more preferably a combination of Ca and Sr.

5. Graphite-based superconducting material according to any one of the preceding claims,
wherein in the melt, the atomic ratio of the non-lithium metal to lithium is in the range from 1:1 to 1:100, in particular from 1:2 to 1:90, in particular from 1:3 to 1:80.

6. Graphite-based superconducting material according to any one of the preceding claims,
wherein in step (B) the temperature of the doping medium is equal to or less than 500 °C when the doping medium comprises the metal as a melt.

7. Graphite-based superconducting material according to any one of the preceding claims,
wherein in step (B) the temperature of the doping medium is equal to or less than 0°C, in particular equal or less than -70°C, when the doping medium comprises the metal as a solution, in particular a metal-ammonia solution.

8. Graphite-based superconducting material according to any one of the preceding claims,
wherein the metal in the doping medium is dissolved in ammonia.

9. Graphite-based superconducting material according to any one of the preceding claims,
wherein the superconducting material has a critical temperature *T_{c}* at atmospheric pressure of 200 K or higher, of 220 K or higher, of 230 K or higher, if 240 K or higher, or of 250 K or higher, or 270 K or higher, or of 350 K or higher when determined by four-probe electrical resistance and/or magnetic susceptibility measurements.

10. Graphite-based superconducting material according to any one of the preceding claims,
wherein the superconducting material at atmospheric pressure has a critical temperature *T_{c}* of 400 K or lower.

11. Graphite-based superconducting phase according to any one of the preceding claims,
wherein the graphite-based material may have, at least in portions thereof, a rhombohedral structure, for example, the graphite-based material has structural domains with a rhombohedral arrangement and stacking faults or irregularities, resulting in the formation of three or more-layer rhombohedral packing of graphene layers in a bulk of the graphite-based material.

12. Graphite-based superconducting material according to any one of the preceding claims,
wherein the metal atoms are intercalated between graphene layers.

13. Graphite-based superconducting material according to any one of the preceding claims,
wherein hydride free and/or sulfur free, in particular hydride and sulfur free.

14. Graphite-based superconducting material according to any one of the preceding claims,
wherein the graphite provided in step (A) is highly oriented pyrolytic graphite or high-purity flexible graphite sheets.

15. Layered material, comprising a graphite-based superconducting material having a critical temperature *T_{c}* of 200 K or higher determined by four-probe electrical resistance and/or magnetic susceptibility measurements,
wherein the layered material comprises a graphite-based host structure, formed of two-dimensional graphene layers,
wherein doping non-lithium metal atoms are intercalated in the host structure, and
wherein in the bulk of the layered material, a ratio of the sum of doping non-lithium metal atoms to carbon atoms is 0.35 or less, optionally 0.15 or less, wherein, in case lithium atoms are present, these lithium ions are not included in the sum of metal atoms.

16. Layered material according to claim 15, wherein the stage of intercalation is in average greater than or equal to 1.

17. Layered material according to claim 15 or 16,
wherein the metal atoms intercalated between the graphene layers comprise lithium atoms and further metal atoms, different from lithium, in particular a divalent metal atom.

18. Layered material according to claim 17,
wherein a ratio of lithium atoms to atoms of a non-lithium metal is equal to or greater than 2.5.

19. Layered material according to at least one of claims 15 to 18,
wherein the graphite-based host structure has at least in portions thereof a rhombohedral structure.

20. Layered material according to at least one of claims 15 or 16, wherein the graphite-based superconducting material, is a graphite-based superconducting phase according to any one of claims 1, 3, 4 and 7 to 14, with the doping medium comprising the non-lithium metal dissolved in a solution.

21. Layered material according to at least one of claims 15 to 19, wherein the graphite-based superconducting material, is a graphite-based superconducting phase according to any one of claims 1 to 6 and 9 to 14, with the doping medium comprising the non-lithium metal as a melt.
